# EUROPEAN PATENT APPLICATION

(11) **EP 3 293 744 A1**
(43) Date of publication of application: **14.03.2018**
(21) Application number: 16789634.9
(22) Date of filing: 04.05.2016
(51) Int. Cl.: H01G 2/14, H01G 4/40, H01C 7/12, H05K 9/00

(54) **ELECTRIC SHOCK-PREVENTION ELEMENT AND ELECTRONIC DEVICE PROVIDED WITH SAME**

(30) Priority: 07.05.2015 KR 20150063841; 04.04.2016 KR 20160041180
(71) Applicant: Moda-Innochips Co., Ltd., Danwon-gu, Ansan-si Gyeonggi-do 15433 (KR)
(72) Inventor: CHO, Seung Hun, Gyeonggi-do (KR); HEO, Sung Jin, Gyeonggi-do (KR); LEE, Dong Suk, Incheon (KR)
(74) Representative: Michalski Hüttermann & Partner Patentanwälte mbB
(86) International application number: PCT/KR2016/004743
(87) International publication number: WO 2016/178528

(57) **Abstract**

Provided are a device for preventing an electric shock and an electronic device including the same. The device for preventing the electric shock includes a stacked body in which a plurality of insulation sheets are stacked, a capacitor part including a plurality of internal electrodes disposed in the stacked body, an ESD protection part disposed on at least a portion of each of the insulation sheets to protect an ESD voltage, and an external electrode disposed on each of at least two side surfaces outside the stacked body and connected to the capacitor part and the ESD protection part. The ESD protection part includes at least two or more discharge electrodes and at least one ESD protection layer disposed between the discharge electrodes and including at least one of a porous insulating material, a conductive material, and an air gap. One of the external electrodes is connected between a metal case of an electronic device and an internal circuit, and the other one of the external electrodes is connected to a ground terminal to block an electric shock voltage and bypass the ESD voltage.

## Description

### BACKGROUND

The present disclosure relates to a device for preventing an electric shock, and more particularly, to a device for preventing an electric shock, which is capable of preventing an electric shock voltage from being transmitted to a user through a chargeable electronic device such as a smartphone.

Mobile communication terminals has changed in main use from the voice communication to the data communication service and then evolved to smart-based life convenience service. Also, as smartphones are multifunctionalized, various frequency bands are being used. That is, a plurality of functions using different frequency bands such as wireless LAN, Bluetooth, and GPS in one smartphone have been adopted. Also, as electronic devices are highly integrated, an internal circuit density in a limited space increases. Thus, noise interference between internal circuits may necessarily occur. A plurality of circuit protection devices for suppressing noises of various frequencies of the portable electronic devices and noises between the internal circuits are being used. For example, a condenser, a chip bead, a common mode filter, and the like, which respectively remove noises of frequency bands different from each other, are being used.

In recent years, with an increased emphasis on the elegant image and durability of the smartphone, the supply of terminals using a metal material is increasing. That is, the supply of a smartphone of which a border is manufactured by using a metal, or the rest case except for a front image display part is manufactured by using a metal is increasing.

However, since an overcurrent protection circuit is not built, or charging is performed by using a non-genuine charger or a faulty charger using a low-quality element, shock current may occur. The shock current may be transmitted to a ground terminal of the smartphone and then transmitted again from the ground terminal to the metal case. Thus, a user contacting the metal case may get shocked. As a result, when the smartphone is used while the smartphone using the metal case is charged by using the non-genuine charger, an electric shock accident may occur.

### (PRIOR ART DOCUMENTS)

Korean Patent Registration No. 10876206

### SUMMARY

The present disclosure provides a device for preventing an electric shock provided in an electronic device such as a smartphone to prevent a user from getting shocked by shock current inputted from a charger.

The present disclosure also provides a device for preventing an electric shock in which dielectric breakdown does not occur by electrostatic discharge (ESD).

In accordance with an exemplary embodiment, a device for preventing an electric shock includes: a stacked body in which a plurality of insulation sheets are stacked; a capacitor part including a plurality of internal electrodes disposed in the stacked body; an ESD protection part disposed on at least a portion of each of the insulation sheets to protect an ESD voltage; and an external electrode disposed on each of at least two side surfaces outside the stacked body and connected to the capacitor part and the ESD protection part, wherein the ESD protection part includes at least two or more discharge electrodes and at least one ESD protection layer disposed between the discharge electrodes, and one of the external electrodes is connected to a metal case of an electronic device, and the other one of the external electrodes is connected to a ground terminal to block an electric shock voltage and bypass the ESD voltage.

The ESD protection layer may include a porous insulating material, a conductive material, and a void, and the void may be formed by connecting at least two voids of the insulating materials adjacent to each other.

The discharge voltage may be less than a discharge starting voltage, and the ESD voltage may be greater than the discharge starting voltage.

The discharge electrode and the ESD protection layer may be respectively disposed on planes different from each other or are disposed on the same plane.

The discharge electrode and the internal electrode adjacent to the discharge electrode may be connected to the same external electrode.

The discharge electrode and the internal electrode adjacent to the discharge electrode may be connected to the external electrodes different from each other.

When a distance between the discharge electrode and the internal electrode adjacent to the discharge electrode is A, a distance between the discharge electrodes is B, and a distance between the internal electrodes is C, A≤C or A≤B may be satisfied.

When the uppermost and lowermost insulation sheets have thickness D1 and D2, B≤D1 and B≤D2 may be satisfied, and D1 may be equal to or different from D2.

Each of the uppermost and lowermost insulation sheets may have a thickness that is equal to or greater than 10 *µ*m and equal to or less than 50% of a thickness of the stacked body.

The discharge electrode may have the same thickness as the internal electrode.

Capacitance may be adjusted outside the stacked body.

The external electrode may extend to at least one of upper and lower portions of the stacked body to partially overlap the internal electrode.

At least two or more capacitor parts and ESD protection parts may be horizontally disposed within the stacked body.

The internal electrodes may be vertically stacked to form one capacitor part and horizontally arranged to form a plurality of capacitor parts.

In accordance with another exemplary embodiment, an electronic device includes a device for preventing an electric shock that is disposed between a metal case and an internal circuit to block an electric shock voltage and bypass an ESD voltage, wherein the device for preventing the electric shock includes: a stacked body in which a plurality of insulation sheets are stacked; a capacitor part including a plurality of internal electrodes disposed in the stacked body; an ESD protection part including at least two or more discharge electrodes disposed on at least a portion of the insulation sheets and at least one ESD protection layer; and an external electrode disposed on each of at least two side surfaces outside the stacked body and connected top the capacitor part and the ESD protection part, and the discharge electrode and the internal electrode adjacent to the discharge electrode are connected to the same external electrode.

In accordance with further another exemplary embodiment, an electronic device includes a device for preventing an electric shock that is disposed between a metal case and an internal circuit to block an electric shock voltage and bypass an ESD voltage, wherein the device for preventing the electric shock includes: a stacked body in which a plurality of insulation sheets are stacked; a capacitor part including a plurality of internal electrodes disposed in the stacked body; an ESD protection part including at least two or more discharge electrodes disposed on at least a portion of the insulation sheets and at least one ESD protection layer; and an external electrode disposed on each of at least two side surfaces outside the stacked body and connected top the capacitor part and the ESD protection part, and the external electrode extends to at least one of upper and lower portions of the stacked body to partially overlap the internal electrode.

When a distance between the discharge electrode and the internal electrode adjacent to the discharge electrode is A, a distance between the discharge electrodes is B, and a distance between the internal electrodes is C, A≤C or A≤B may be satisfied.

When the uppermost and lowermost insulation sheets have thickness D1 and D2, B≤D1 and B≤D2 may be satisfied, and D1 may be equal to or different from D2.

The discharge electrode and the internal electrode may have the same thickness.

### BRIEF DESCRIPTION OF THE DRAWINGS

Exemplary embodiments can be understood in more detail from the following description taken in conjunction with the accompanying drawings, in which:
FIG. 1 is a perspective view of a device for preventing an electric shock in accordance with an exemplary embodiment;
FIG. 2 is a cross-sectional view taken along line A-A of FIG. 1.
FIG. 3 is an equivalent circuit diagram of the device for preventing the electric shock in accordance with an exemplary embodiment;
FIGS. 4 and 5 are a cross-sectional view and a cross-sectional photograph illustrating an ESD protection layer of a device for preventing an electric shock in accordance with exemplary embodiments;
FIG. 6 is a cross-sectional view of a device for preventing an electric shock in accordance with another exemplary embodiment;
FIG. 7 is a cross-sectional view of a device for preventing an electric shock in accordance with further another exemplary embodiment;
FIGS. 8 to 14 are schematic views illustrating modified examples of a device for preventing an electric shock in accordance with further another exemplary embodiment;
FIGS. 15 to 18 are cross-sectional views of a device for preventing an electric shock in accordance with further another exemplary embodiment; and
FIGS. 19 to 22 are cross-sectional views of a device for preventing an electric shock in accordance with further another exemplary embodiment; and
FIGS. 23 to 26 are views of a discharge starting voltage according to various experimental examples of an ESD protection layer in accordance with exemplary embodiments.

### DETAILED DESCRIPTION OF EMBODIMENTS

Hereinafter, specific embodiments will be described in detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art.

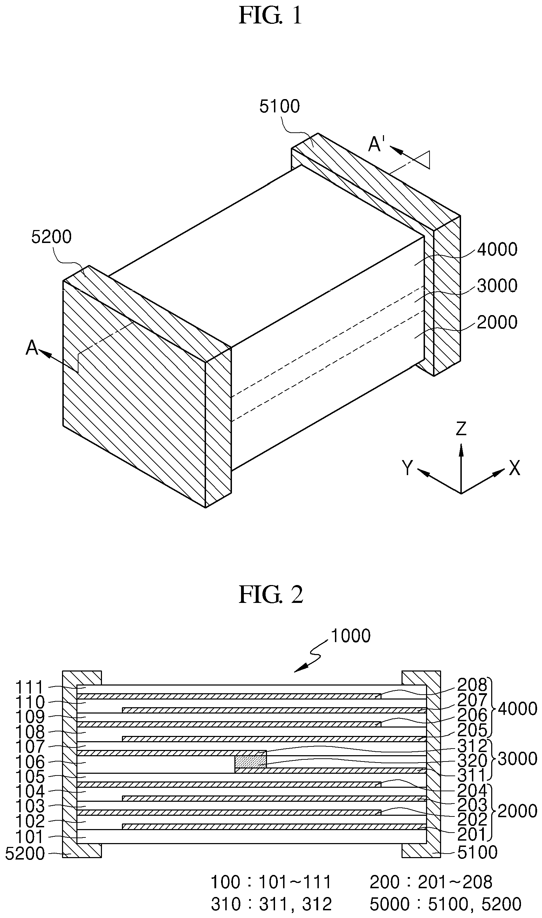

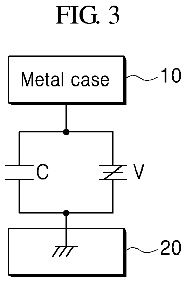

FIG. 1 is a perspective view of a device for preventing an electric shock in accordance with an exemplary embodiment, FIG. 2 is a cross-sectional view taken along line A-A' of FIG. 1, and FIG. 3 is an equivalent circuit diagram of the device for preventing the electric shock.

Referring to FIGS. 1 to 3, a device for preventing an electric shock in accordance with an exemplary embodiment may include a stacked body 1000 on which a plurality of insulation sheets 100 (101 to 111) are stacked, at least one capacitor part 200 and 400 provided in the stacked body 1000 and including a plurality of internal electrodes 200 (201 to 208), and an ESD protection part 3000 including at least one discharge electrode 310 (311 and 312) and an ESD protection layer 320. For example, first and second capacitor parts 2000 and 4000 may be disposed in the stacked body 1000, and the ESD protection layer 3000 may be disposed between the first and second capacitor parts 2000 and 4000. That is, the first capacitor part 200, the ESD protection part 3000, and the second capacitor part 4000 are stacked in the stacked body 1000 to realize the device for preventing the electric shock. Also, the device for preventing the electric shock may further include external electrodes 5000 (5100 and 5200) disposed on two side surfaces facing each other of the stacked body 1000 to connect the first and second capacitor parts 2000 and 4000 to an ESD protection part 3000. Alternatively, the device for preventing the electric shock may include at least one capacitor part and at least one ESD protection part. That is, one capacitor part may be disposed below or above the ESD protection part 3000, and at least one capacitor part may be disposed above and below at least two ESD protection parts 3000 spaced apart from each other. The device for preventing the electric shock may be disposed between an internal circuit, e.g., a PCB, and a metal case of an electronic device to block an electric shock voltage, bypass an ESD voltage, and continuously block the electric shock voltage because electric breakdown does not occur by the ESD.

The stacked body 1000 may be manufactured by stacking the plurality of insulation sheets 100 (101 and 111). The stacked body 1000 may have an approximately hexahedral shape that has predetermined lengths in one direction (e.g., an X-direction) and the other direction (e.g., a Y-direction) perpendicular to the one direction and has a predetermined height in a vertical direction (e.g., a Z-direction). That is, when a formation direction of the external electrode 500 is defined as the X-direction, a direction horizontally perpendicular to the X-direction may be defined as the Y-direction, and a vertical direction of the X-direction may be defined as the Z-direction. Here, the length in the X-direction may be greater than each of the length in the Y-direction and the length in the Z-direction. The length in the Y-direction may be equal to or different from that in the Z-direction. When the lengths in the Y and Z-directions are different from each other, the length in the Y-direction may be greater or less than that in the Z-direction. For example, a ratio of the lengths in the X, Y, and Z-directions may be 2 to 5:1:0.5 to 1. That is, the length in the X-direction may be greater by 2 times to 5 times than that in the Y-direction, and the length in the Z-direction may be greater by 0.5 times to 1 time than that in the Y-direction. However, the lengths in the X, Y, and Z-directions may be merely examples. For example, the lengths in the X, Y, and Z-directions may variously vary according to an inner structure of the electronic device connected to the device for preventing the electric shock and a shape of the device for preventing the electric shock. Also, at least one capacitor part 2000 and 4000 and at least one ESD protection part 3000 may be provided in the stacked body 1000. For example, the first capacitor part 2000, the ESD protection part 3000, and the second capacitor part 4000 may be disposed in a stacking direction of the sheets 100, i.e., in the Z-direction. Each of the plurality of insulation sheets 100 may has a predetermined dielectric constant, for example, a dielectric constant of 10 to 20,000. Each of the insulation sheets 100 may be formed of a material containing at least one of dielectric material powder such as MLCC, BaTiO₃, BaCO₃, TiO₂, Nd₂O₃, Bi₂O₃, Zn0, and Al₂O₃. Also, the plurality of insulation sheets 100 may have the same thickness, or at least one insulation sheet 100 may have a thickness greater or less than that of the other insulation sheet 100. That is, the insulation sheet of the ESD protection part 3000 may have a thickness different from that of the insulation sheet of each of the first and second capacitor parts 2000 and 4000. Also, each of the insulation sheets disposed between the ESD protection member 3000 and the first and second capacitor parts 2000 and 4000 may have a thickness different from that of the other insulation sheet. For example, each of the insulation sheets disposed between the ESD protection part 3000 and the first and second capacitor parts 2000 and 4000, i.e., each of fifth and seventh insulation sheets 105 and 107 may have a thickness less than or equal to that of the insulation sheet of the ESD protection part 3000, i.e., a sixth insulation sheet 106 or have a thickness less than or equal to that of each of the insulation sheets 102 to 104 and 108 to 110 disposed between the internal electrodes of the first and second capacitor parts 2000 and 4000. That is, a space between the ESD protection part 3000 and each of the first and second capacitor parts 2000 and 4000 may be less than or equal to that between the internal electrodes of the first and second capacitor parts 2000 and 4000 or may be less than or equal to the thickness of the ESD protection part 3000. Alternatively, the insulation sheets 102 to 104 and 108 to 110 of the first and second capacitor parts 2000 and 4000 may have the same thickness, or one insulation sheet may have a thickness less or greater than that of the other insulation sheet. Each of the insulation sheets 100 may have a thickness at which the insulation sheets are not broken when the ESD is applied, i.e., a thickness of 5 *µ*m to about 300 *µ*m. Also, the stacked body 1000 may further include a lower cover layer (not shown) and an upper cover layer (not shown), which are respectively disposed on upper and lower portions of each of the first and second capacitor parts 2000 and 4000. Alternatively, the first insulation sheet 101 may function as the lower cover layer, and an eleventh insulation sheet 111 may function as the upper cover layer. The lower and upper cover layers may be prepared by stacking a plurality of ferrite sheets on each other and have the same thickness. Here, a non-magnetic sheet, e.g., a sheet formed of a glass material may be further disposed on the outermost portions of the lower and upper cover layers constituted by the ferrite sheets, i.e., surfaces of the lower and upper portions of the cover layers. Also, each of the lower and upper cover layers may have a thickness greater than that of each of the insulation sheets therein, i.e., the second to tenth insulation sheets 102 to 110. Thus, when the first and eleventh insulation sheets 101 and 111 respectively function as the lower and upper cover layers, each of the first and eleventh insulation sheets 101 and 111 may have a thickness greater than that of each of the second to tenth insulation sheets 102 to 110.

The first capacitor part 2000 may be disposed below the ESD protection part 3000 and include at least two internal electrodes and at least two insulation sheets between the at least two internal electrodes. For example, the first capacitor part 2000 may include the first to fourth insulation sheets 101 to 104 and the first to fourth internal electrodes 201 to 204 that are respectively disposed on the first to fourth insulation sheets 101 to 104. For example, each of the first to fourth internal electrodes 201 to 204 may have a thickness of 1 *µ*m to 10 *µ*m. Here, the first to fourth internal electrodes 201 to 204 may have sides connected to the external electrodes 5000 (5100 and 5200) facing each other in the X-direction and the other sides spaced apart from each other. The first and third internal electrodes 201 and 203 have predetermined areas on the first and third insulation sheets 101 and 103, respectively. Also, each of the first and third internal electrodes 201 and 203 has one side connected to the first external electrode 5100 and the other side spaced apart from the second external electrode 5200. The second and fourth internal electrodes 202 and 204 may have predetermined areas on the second and fourth insulation sheets 102 and 104, respectively. Also, each of the second and fourth internal electrodes 202 and 204 may have one side connected to the second external electrode 5200 and the other side spaced apart from the first external electrode 5100. That is, the first to fourth internal electrodes 201 to 204 may be alternately connected to one of the external electrodes 5000 to allow predetermined areas of the first to fourth internal electrodes 201 to 204 to respectively overlap the second to fourth insulation sheets 101 to 104 with the second to fourth insulation sheets 101 to 104 therebetween. Here, 10% to 85% of an area of each of the first to fourth internal electrodes 201 and 204 to that of each of the first to fourth insulation sheets 101 to 104 may overlap each of the first to fourth insulation sheets 101 to 104. Also, 10% to 85% of an area of each of the first to fourth internal electrodes 201 to 204 to the total area thereof may overlap. Each of the first to fourth internal electrodes 201 to 204 may have various shapes such as a square shape, a rectangular shape, a predetermined pattern shape, and a spiral shape having a predetermined width and distance. The first capacitor part 2000 has capacitance between the first to fourth internal electrodes 201 to 204. The capacitance may be adjusted according to the overlapping area of each of the first to fourth internal electrodes 201 to 204 and the thickness of each of the insulation sheets 101 to 104. The first capacitor part 2000 may further include at least one internal electrode in addition to the first to fourth internal electrodes 201 to 204 and at least one insulation sheet on which the at least one internal electrode is disposed. Also, the first capacitor part 2000 may include two internal electrodes. Although the first capacitor part 2000 including four internal electrodes is described as an example, at least two internal electrodes, i.e., a plurality of internal electrodes may be provided.

The ESD protection part 3000 may include at least two discharge electrodes 310 (311 and 312) that are vertically spaced apart from each other and at least one ESD protection layer 320 disposed between the at least two discharge electrodes 310. For example, the ESD protection part 3000 may include fifth and sixth insulation sheets 105 and 106, first and second discharge electrodes 311 and 312 respectively disposed on the fifth and sixth insulation sheets 105 and 106, and an ESD protection layer passing through the sixth insulation sheet 106. Here, the ESD protection layer 320 may have at least a portion connected to the first and second discharge electrodes 311 and 312. The first and second discharge electrodes 311 and 312 may have the same thickness as each of the internal electrodes 200 of the capacitor parts 2000 and 4000. For example, each of the first and second discharge electrodes 311 and 312 may have a thickness of 1 *µ*m to 10 *µ*m. However, each of the first and second discharge electrodes 311 and 312 may have a thickness less than that of the internal electrode 200 of each of the capacitor parts 2000 and 4000. The first discharge electrode 311 may be connected to the first external electrode 5100 and disposed on the fifth insulation sheet 105 and have an end connected to the ESD protection layer 320. The second discharge electrode 312 be connected to the second external electrode 5200 and disposed on the sixth insulation sheet 106 and have an end connected to the ESD protection layer 320. Here, an area of each of the first and second discharge electrodes 311 and 312, which contacts the ESD protection layer 320, may be equal to or less than that of the ESD protection layer 320. Also, the first and second discharge electrodes 311 and 312 may completely overlap the ESD protection layer 320 without getting out of the ESD protection layer 320. That is, edges of the first and second discharge electrodes 311 and 312 may vertically match an edge of the ESD protection layer 320 to form a vertical component. Alternatively, the first and second discharge electrodes 311 and 312 may overlap a portion of the ESD protection layer 320. For example, each of the first and second discharge electrodes 311 and 312 may overlap 10% to 100% of a horizontal area of the ESD protection layer 320. That is, the end of each of the first and second discharge electrodes 311 and 312 may be formed without getting out of the ESD protection layer 320. An area of each of the first and second discharge electrodes 311 and 312, which contacts the ESD protection layer 320, may be greater than an area of each of the first and second discharge electrodes 311 and 312, which does not contact the ESD protection layer 320. The ESD protection layer 320 may be connected to a predetermined area of the sixth insulation sheet 106. For example, the ESD protection layer 320 may be disposed at a central portion and connected to the first and second discharge electrodes 311 and 312. Here, at least a portion of the ESD protection layer 320 may overlap each of the first and second discharge electrodes 311 and 312. That is, 10% to 100% of the horizontal area of the ESD protection layer 320 may overlap each of the first and second discharge electrodes 311 and 312. The ESD protection layer 320 may have a through hole having a predetermined size in a predetermined area, e.g., the central portion of the sixth insulation sheet 106. Then, the through hole may be filled through a thick film printing process. For example, the ESD protection layer 330 may have a diameter of 100 *µ*m to 500 *µ*m and a thickness of 10 *µ*m to 50 *µ*m. Here, when the thickness of the ESD protection layer 320 is thinner, the discharge starting voltage may be reduced. The ESD protection layer 320 may be formed of a conductive material and an insulating material. For example, a mixed material of conductive ceramic and insulating ceramic may be printed on the sixth insulation sheet 106 to form the ESD protection layer 320. The ESD protection layer 320 may be disposed on at least one insulation sheet 100. That is, the ESD protection layer 320 may be disposed on at least one insulation sheet 100 that vertically stacked on each other, e.g., two insulation sheets 100. Here, the discharge electrodes may be disposed to be spaced apart from each other on the insulation sheets 100 and be connected to the ESD protection layer 320. A structure and material of the ESD protection layer 320 will be described later in more detail.

The second capacitor part 4000 may be disposed above the ESD protection part 3000 and include at least two internal electrodes and at least two insulation sheets between the at least two internal electrodes. For example, the second capacitor part 2000 may include the seventh to tenth insulation sheets 107 to 110 and the fifth to eighth internal electrodes 205 to 208 that are respectively disposed on the seventh to tenth insulation sheets 107 to 110. Here, the fifth to eighth internal electrodes 205 to 208 may have sides connected to the external electrodes 5000 (5100 and 5200) facing each other in the X-direction and the other sides spaced apart from each other. Each of the fifth and seventh internal electrodes 201 and 205 has a predetermined area on each of the seventh and ninth insulation sheets 107 and 109. Also, each of the fifth and seventh internal electrodes 205 and 207 has one side connected to the first external electrode 5100 and the other side spaced apart from the second external electrode 5200. The sixth and eighth internal electrodes 206 and 208 may have predetermined areas on the eighth and tenth insulation sheets 108 and 110, respectively. Also, each of the second and fourth internal electrodes 202 and 204 may have one side connected to the second external electrode 5200 and the other side spaced apart from the first external electrode 5100. That is, the fifth to eighth internal electrodes 205 to 208 may be alternately connected to one of the external electrodes 5000 to allow predetermined areas of the fifth to eight internal electrodes 205 to 208 to respectively overlap the eighth to tenth insulation sheets 108 to 110 with the eighth to tenth insulation sheets 108 to 110 therebetween. Here, 10% to 85% of an area of each of the fifth to eight internal electrodes 205 and 208 to that of each of the seventh to tenth insulation sheets 107 to 110 may overlap each of the seventh to tenth insulation sheets 107 to 110. Also, 10% to 85% of an area of each of the fifth to eight internal electrodes 205 to 208 to the total area thereof may overlap. For example, each of the fifth to eight internal electrodes 205 to 208 may have a thickness of 1 *µ*m to 10 *µ*m. Each of the fifth to eight internal electrodes 205 to 208 may have various shapes such as a square shape, a rectangular shape, a predetermined pattern shape, and a spiral shape having a predetermined width and distance. The second capacitor part 4000 has capacitance between the fifth to eight internal electrodes 205 to 208. The capacitance may be adjusted according to the overlapping area of each of the fifth to eight internal electrodes 205 to 208 and the thickness of each of the insulation sheets 108 to 110. The second capacitor part 4000 may further include at least one internal electrode in addition to the third and fourth internal electrodes 203 to 204 and at least one insulation sheet on which the at least one internal electrode is disposed. Also, the second capacitor part 4000 may include two internal electrodes. Although the second capacitor part 4000 including four internal electrodes is described as an example, at least two internal electrodes, i.e., a plurality of internal electrodes may be provided.

Each of the internal electrodes 210 to 204 of the first capacitor part 2000 and each of the internal electrodes 205 to 208 of the second capacitor part 4000 may have the same shape and area and also the same overlapping area. Also, each of the insulation sheets 101 to 104 of the first capacitor part 2000 and each of the insulation sheets 107 to 110 of the second capacitor part 4000 may have the same thickness. Here, when the first insulation sheet 101 functions as the lower cover layer, the first insulation sheet 101 may have a thickness greater than that of each of the rest insulation sheets. Thus, the first and second capacitor parts 2000 and 4000 may have the same capacitance. However, the first and second capacitor parts 2000 and 4000 may have capacitances different from each other. In this case, at least one of the areas of the internal electrodes, the overlapping areas of the internal electrodes, and the thicknesses of the insulation sheets may be different from each other. Also, each of the internal electrodes 210 to 208 of the capacitor parts 2000 and 4000 may have a length greater than that of the discharge electrode 310 of the ESD protection part 3000 and an area greater than that of the discharge electrode 310.

The external electrodes 5000 (5100 and 5200) are disposed on two side surfaces facing each other of the stacked body 1000 and connected to the first and second capacitor parts 2000 and 4000 and the internal electrodes of the ESD protection part 3000. Each of the external electrodes 5000 may be provided as at least one layer. The external electrode 5000 may be formed of a metal layer such as Ag, and at least one plating layer may be disposed on the metal layer. For example, the external electrode 5000 may be formed by stacking a cupper layer, an Ni-plated layer, and an Sn- or Sn/Ag-plated layer. Also, the external electrode 5000 may be formed by mixing, for example, multicomponent glass frit using Bi₂O₃ or SiO₂ of 0.5% to 20% as a main component with metal powder. Here, the mixture of the glass frit and the metal powder may be prepared in the form of paste and applied to two surface of the stacked body 1000. As described above, since the glass frit is contained in the external electrode 5000, adhesion force between the external electrode 5000 and the stacked body 1000 may be improved, and a contact reaction between the internal electrode 200 and the external electrode 5000 may be improved. Also, after the conductive paste containing glass is applied, at least one plating layer may be disposed on the conductive paste to form the external electrode 5000. That is, the metal layer containing the glass may be provided, and the at least one plating layer may be disposed on the metal layer to form the external electrode 5000. For example, in the external electrode 5000, after the layer containing the glass frit and at least one of Ag and Cu is formed, electroplating or electroless plating may be performed to successively form the Ni-plated layer and the Sn-plated layer. Here, the Sn-plated layer may have a thickness equal to or greater than that of the Ni-plated layer. The external electrode 5000 may have a thickness of 2 *µ*m to 100 *µ*m. Here, the Ni-plated layer may have a thickness of 1 *µ*m to 10 *µ*m, and the Sn or Sn/Ag-plated layer may have a thickness of 2 *µ*m to 10 *µ*m.

Also, before the external electrode 5000 is formed, oxide powder may be distributed on a surface of the stacked body. Here, the oxide powder may be formed before a portion of the external electrode 5000 is formed through the printing process or distributed before the plating process is performed. That is, the oxide powder may be distributed on the surface of the stacked body before the plating process when the external electrode 5000 is formed through the plating process. Since the oxide powder is distributed before the plating process, resistance on the surface of the stacked body may be uniform, and thus, the plating process may be uniformly performed. That is, resistance on at least an area of the surface of the stacked body may be different from that on the other area of the surface of the stacked body. For example, when the plating process is performed, the plating process may be well performed on an area having relatively low resistance than an area having relatively high resistance to cause ununiformity in growth of the plating layer. Thus, to solve the above-described limitation, the surface resistance of the stacked body has to be uniformly maintained. For this, the oxide powder may be distributed on the surface of the stacked body. Here, the oxide powder may be distributed on an entire surface of the stacked body and provided in the form of a layer. Alternatively, the oxide powder may be partially distributed on the surface of the stacked body. Here, the oxide powder may be distributed in the form of the layer on at least one area and partially distributed on at least one area. For example, the oxide powder may be distributed on the entire surface of the stacked body and then connected to form an oxide layer having a predetermined thickness. Here, since the oxide layer is formed on the surface of the stacked body, the surface of the stacked body may not be exposed. Also, the oxide powder may be distributed in the form of an island on the surface of the stacked body. That is, the oxide powder may be disposed to be spaced apart from each other in the form of the island on the surface of the stacked body. Thus, at least a portion of the surface of the stacked body may be exposed. Also, the oxide powder may be formed on the form of the layer on the at least one area and distributed in the form of the island on at least a portion of the surface of the stacked body. That is, at least two oxide powder may be connected to each other to form the layer on at least one area and the island shape on at least one area. That is, the oxide powder may be disposed to be spaced apart from each other in the form of the island on the surface of the stacked body. Thus, at least a portion of the surface of the stacked body may be exposed. The total area of the oxide powder that is distributed in the form of the island on the at least a portion of the surface of the stacked surface may be, for example, 10% to 80% of the total area of the surface of the stacked body. Here, at least one metal oxide may be used as the oxide powder for realizing the uniform surface resistance of the stacked body. For example, at least one material including Bi₂O₃, BO₂, B₂O₃, ZnO, CO₃O₄, SiO₂, Al₂O₃, and MnO may be used as the oxide powder.

Here, a distance between the ESD protection part 3000 and each of the capacitor parts 2000 and 4000 may be less than or equal to that between the two internal electrodes within the capacitor parts 2000 and 4000. That is, each of the fifth and seventh insulation sheets 105 and 107 disposed between the ESD protection part 3000 and each of the capacitor parts 2000 and 4000 may have a thickness less than or equal to that of each of the insulation sheets 102 to 104 and 107 to 110 disposed between the internal electrodes 200 within the capacitor parts 2000 and 4000. Also, a distance between the ESD protection part 3000 and each of the capacitor parts 2000 and 4000 may be less than or equal to that between the two discharge electrodes 310 of the ESD protection part 3000. That is, each of the fifth and seventh insulation sheets 105 and 107 disposed between the ESD protection part 3000 and each of the capacitor parts 2000 and 4000 may have a thickness less than or equal to that of the sixth insulation sheet 106 on which the ESD protection layer 320 is disposed. As a result, each of the fifth and seventh insulation sheets 105 and 107 disposed between the ESD protection part 3000 and each of the capacitor parts 2000 and 4000 may have a thickness less than or equal to that of each of the insulation sheets 102 to 104 and 107 to 110 disposed between the internal electrodes 200 within the capacitor parts 2000 and 4000 or have a thickness less than or equal to a distance B between the two discharge electrodes 310 of the ESD protection part 3000. That is, if distances between the ESD protection part 3000 and the capacitor parts 2000 and 4000 are A1 and A2, distance between the two internal electrodes within the capacitor parts 2000 and 4000 are C1 and C2, and a distance between the two discharge electrodes 300 of the ESD protection part 3000 is B, the following equation, which is expressed by A1=A2≤C1=C2 or A1=A2≤B, may be satisfied. Alternatively, A1 may be different from A2, and C1 may be different from C2. Each of the lowermost insulation sheet and the uppermost insulation sheet, i.e., the first and eleventh insulation sheet 101 and 111 may have a thickness that is greater than 10 *µ*m and corresponds to 50% or less of the thickness of the stacked body 1000. Here, when the first and eleventh insulation sheets 101 and 111 have thicknesses D1 and D2, respectively, the following equation that is expressed by B≤D1=D2, may be satisfied, where the thickness D1 may be different from the thickness D2.

Although the ESD protection part 3000 including one ESD protection layer 320 within the stacked body 1000 is provided in accordance with an exemplary embodiment, two or more EDS protection layers 320, i.e., a plurality of ESD protection layers may be provided, and the ESD protection part 3000 may be provided in plurality. For example, at least two ESD protection layers 320 may be vertically disposed, and the discharge electrode may be further disposed between the ESD protection layers 320 so that one device for preventing the electric shock may be constituted by at least one capacitor part and at least two ESD protection parts. Also, the internal electrodes 200 of the capacitor parts 2000 and 4000 and the discharge electrode 310 and the ESD protection layer 320 of the ESD protection part 3000 may be provided in at least two or more in the Y-direction. Thus, a plurality of devices for preventing the electric shock may be provided in parallel to each other within one stacked body 1000.

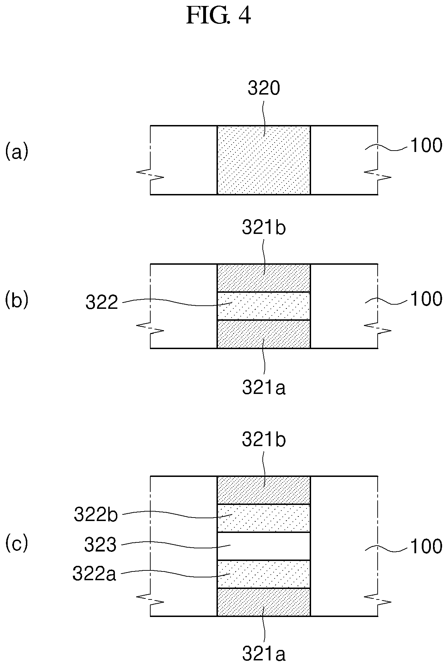

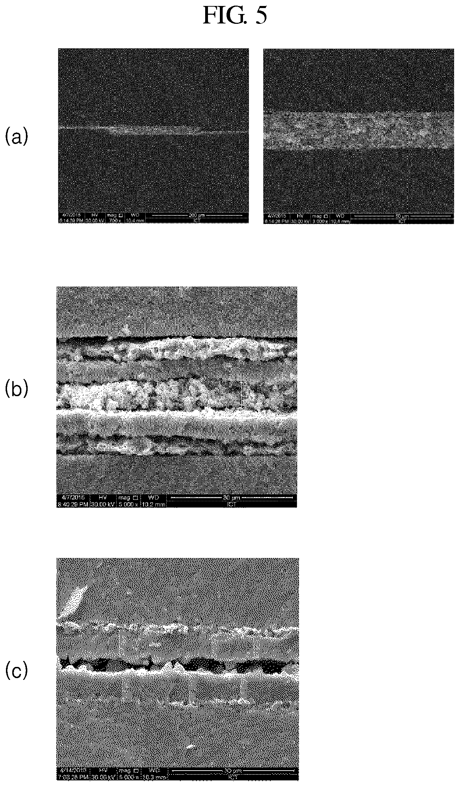

FIGS. 4 and 5 are a cross-sectional view and a cross-sectional photograph of the ESD protection layer 320 of the device for preventing the electric shock in accordance with an exemplary embodiment.

As illustrated in (a) of FIG. 4 and (a) of FIG. 5, the ESD protection layer 320 may be formed by mixing a conductive material with an insulating material. For example, the conductive ceramic and the insulating ceramic may be mixed with each other to form the ESD protection layer 320. In this case, the ESD protection layer 320 may be formed by mixing the conductive ceramic with the insulating ceramic at a mixing ratio of, for example, 10:90 to 90:10. The more the mixing ratio of the insulating ceramic increases, the more the discharge starting voltage increases. Also, the more the mixing ratio of the conductive ceramic increases, the more the discharge starting voltage decreases. Thus, the mixing ratio of the conductive ceramic and the insulating ceramic may be adjusted to obtain a predetermined discharge starting voltage. Here, a plurality of pores (not shown) may be formed in the ESD protection layer 320. Since the pores are formed, the ESD voltage may be more easily bypassed.

Also, the ESD protection layer 300 may have a predetermined stacked structure in which the conductive layer and the insulation layer are stacked. That is, the conductive layer and the insulation layer may be stacked at least once so as to be separated from each other, thereby forming the ESD protection layer 300. For example, the ESD protection layer 320 may have a two-layered structure in which the conductive layer and the insulation layer are stacked or a three-layered structure in which the conductive layer, the insulation layer, and the conductive layer are stacked. Also, the conductive layer 321 and the insulation layer 322 may be stacked several times to form an at least three-layered structure. For example, as illustrated in (b) of FIG. 4, an ESD protection layer 300 having a three-layered structure in which a first conductive layer 321a, an insulation layer 322, and a second conductive layer 321b are stacked may be formed. (b) of FIG. 5 illustrates a photograph of the ESG protection layer having the three-layered structure between the internal electrodes that are disposed between the insulation sheets. When the conductive layer and the insulation layer are stacked several times, the conductive layer may be disposed at the uppermost layer and the lowermost layer. Here, a plurality of pores (not shown) may be formed in at least a portion of each of the conductive layer 321 and the insulation layer 322. For example, since the insulation layer disposed between the conductive layers 321 has a porous structure, the plurality of pores may be formed in the insulation layer 322.

Also, a void may be further formed in a predetermined area of the ESD protection layer 320. For example, a void may be formed between the layers in which the conductive material and the insulating material are mixed or formed between the conductive layer and the insulation layer. That is, a first mixed layer in which the conductive layer and the insulating material are mixed, a void, and a second mixed layer may be stacked, or the conductive layer, a void, and an insulation layer may be stacked. For example, as illustrated in (c) of FIG. 4, a first conductive layer 321a, a first insulation layer 322a, a void 323, a second insulation layer 322b, and a second conductive layer 321b may be stacked to form the ESD protection layer 320. That is, the insulation layers 322 may be disposed between the conductive layers 321, and the void may be formed between the insulation layers 322. (c) of FIG. 5 illustrates a photograph of a cross-section of the ESD protection layer 320 having the above-described stacked structure. Alternatively, the conductive layer, the insulation layer, and the void may be repeatedly stacked to form the ESD protection layer 320. When the conductive layer 321, the insulation layer 322, and the void 323 are stacked, the conductive layer 321, the insulation layer 322, and the void 323 may have the same thickness, or at least one of the conductive layer 321, the insulation layer 322, and the void 323 may have a thickness less than those of other components. For example, the void 323 may have a thickness less than that of each of the conductive layer 321 and the insulation layer 322. Also, the conductive layer 321 may have the same thickness as the insulation layer 322 or have a thickness greater or less than that of the insulation layer 322. A firing process may be performed after a polymer material is filled, and then, the polymer material may be removed to form the void 323. For example, a first polymer material containing the conductive ceramic, a second polymer material containing the insulating ceramic, and a third polymer material in which the conductive ceramic or the insulating ceramic is not contained may be filled into a via hole, and then, the firing process is performed to remove the polymer material, thereby forming the conductive layer, the insulation layer, and the void. The void 323 may be formed without being separated from the other layer. For example, the insulation layer 322 may be disposed between the conductive layers 321a and 321b, and a plurality of voids are vertically or horizontally connected to the inside of the insulation layer 322 to form the void 323. That is, the void 323 may be provided as a plurality of pores within the insulation layer 322. Alternatively, the void 323 may be formed in the conductive layer 321 as the plurality of pores.

Also, in the ESD protection layer 320, the ESD protection material containing the porous insulating material and the conductive material may be applied to a portion of the hole, but not applied to other portions to form the void. Alternatively, in the ESD protection layer 320, the ESD protection material is formed in the through hole, and the void may be formed between the two discharge electrodes 311 and 312.

The conductive layer 321 used for the ESD protection layer 320 may have predetermined resistance to allow current to flow. For example, the conductive layer 321 may be a resistor having resistance of several Ω to several tens MΩ. The conductive layer 321 may reduce an energy level when a voltage such as the ESD is excessively introduced to prevent the device for preventing the electric shock from being structurally broken by the overvoltage. That is, the conductive layer 321 may function as a heat sink that coverts electric energy into heat energy. The conductive layer 321 may be formed by using conductive ceramic. The conductive ceramic may use a mixture containing at least one of La, Ni, Co, Cu, Zn, Ru, Ag, Pd, Pt, W, Fe, and Bi. Also, the conductive layer 321 may have a thickness of 1 *µ*m to 50 *µ*m. That is, when the conductive layer 321 are provided as a plurality of layers, the sum of the thicknesses of the conductive layers 321 may be 1 *µ*m to 50 *µ*m.

Also, the insulation layer 322 used for the ESD protection layer 320 may be formed f a discharge inducing material to function as an electric barrier having a porous structure. The insulation layer 322 may be formed of insulating ceramic, and a ferroelectric material having a dielectric constant of approximately 50 to approximately 50,000 may be used as the insulating ceramic. For example, the insulating ceramic may be formed by using a mixture containing at least one of dielectric material powder such as MLCC, BaTiO₃, BaCO₃, TiO₂, Nd, Bi, Zn, and Al₂O₃. The insulation layer 322 may have a porous structure in which a plurality of pores, each of which has a size of approximately 1 nm to approximately 5 *µ*m, are formed to have porosity of 30% to 80%. Here, the shortest distance between the pores may be approximately 1 nm to approximately 5 *µ*m. That is, although the insulation layer 322 is formed of an electrical insulating material through which current does not flow, since the pores are formed, the current may flow through the pores. Here, when the pore increases in size, or the porosity increases, the discharge starting voltage may decrease. On the other hand, when the pore decreases in size, or the porosity decreases, the discharge starting voltage may increase. However, if the size of the pore exceeds 5 *µ*m, or the porosity exceeds 80%, it may be difficult to maintain the configuration of the ESD protection layer 320. Thus, to maintain the configuration of the ESD protection layer 320, the discharge starting voltage may be adjusted to adjust the size of the pore and the porosity of the insulation layer 322. When the ESD protection layer 320 is formed of the mixed material of the insulating material and the conductive material, the insulating material may use the insulating ceramic having fine pores and porosity. Also, the insulation layer 322 may have resistance less than that of the insulation sheet 100 by the fine pores, and partial discharge may be performed through the fine pores. That is, the fine pores are formed in the insulation layer 322, and thus, the partial discharge is performed through the fine pores. The insulation layer 322 may have a thickness of 1 *µ*m to 50 *µ*m. That is, when the insulation layer 322 are provided as a plurality of layers, the sum of the thicknesses of the insulation layers 322 may be 1 *µ*m to 50 *µ*m.

As described above, the device for preventing the electric shock in accordance with an exemplary embodiment may be disposed between the metal case 10 and the internal circuit 20 of the electronic device as illustrated in FIG. 3. That is, one of the external electrodes 5000 may be connected to the metal case 10 of the electronic device, and the other one may be connected to the ground terminal. Here, the ground terminal may be disposed in the internal circuit 20. For example, the first external electrode 5100 may be connected to the metal case 10 of the electronic device, and the second external electrode 5200 may be connected to the ground terminal. Thus, the electric shock voltage transmitted from the ground terminal of the internal circuit 20 to the metal case may be blocked, and the ESD voltage applied to the internal circuit from the outside may be bypassed to the ground terminal. That is, in the device for preventing the electric shock, current does not flow between the external electrodes 5000 at a rated voltage and the electric shock voltage, but flows through the ESD protection part 3000 at the ESD voltage to allow the ESD voltage to be bypassed to the ground terminal. In the device for preventing the electric shock, the discharge starting voltage may be greater than a rated voltage and less than the ESD voltage. For example, in the device for preventing the electric shock, the rated voltage may be 100 V to 240 V, the electric shock voltage may be equal to or greater than an operation voltage of the circuit, and the ESD voltage generated by external static electricity may be greater than the electric shock voltage. Also, a communication signal may be transmitted between the outside and the internal circuit 20 by the capacitor parts 2000 and 4000. That is, the communication signal from the outside, i.e., an RF signal may be transmitted to the internal circuit 20 by the capacitor parts 2000 and 4000, and the communication signal from the internal circuit 20 may be transmitted to the outside by the capacitor parts 2000 and 4000. Event when the metal case 10 is used as an antenna without providing a separate antenna, the communication signal may be transmitted to and received from the outside by using the capacitor parts 2000 and 4000. As a result, the device for preventing the electric shock in accordance with an exemplary embodiment may block the electric shock voltage and bypass the ESD voltage to the ground terminal, and transmit the communication signal between the outside and the electronic device.

Also, in the device for preventing the electric shock in accordance with an exemplary embodiment, the plurality of insulation sheets, each of which has a high resistance property, may be stacked to form the capacitor part. Thus, when an electric shock voltage of 310 V is introduced from the internal circuit to the metal case by the faulty charger, the insulation resistance state may be maintained to prevent leakage current from flowing. Also, when the ESD voltage is introduced into the internal circuit from the metal case, the ESD protection part may bypass the ESD voltage to maintain the high insulation resistance state without damaging the device. That is, the ESD protection part 3000 may include the ESD protection layer 300 including the conductive layer 310 that reduces the energy level to convert the electric energy into the heat energy and the insulation layer 320 having the porous structure to allow the current to flow through the fine pores to bypass the ESD voltage applied from the outside, thereby protecting the circuit. Thus, the ESD protection part 300 may be disposed in the electronic device including the metal case to continuously prevent the electric shock generated in the faulty charger from being transmitted to the user through the metal case of the electronic device without dielectric breakdown. A general multi layer capacitance circuit (MLCC) may protect the electric shock voltage, but be weak to the ESD. Thus, when the ESD is repeatedly applied, spark may occur by a leak point due to the electric charging to damage the device. However, since the ESD protection layer including the conductive layer and the insulation layer is disposed between the capacitor parts in accordance with an exemplary embodiment, the ESD voltage may be bypassed through the ESD protection layer so that the capacitor parts are not broken.

For example, the device for preventing the electric shock has a length L of 0.3 mm to 1.1 mm in one direction, i.e., the X-direction, a width W 0.15 mm to 0.55 mm in the other direction perpendicular to the one direction, i.e., the Y-direction, and a thickness of 0.15 mm to 0.55 mm in the Z-direction. For example, the length, the width, and the thickness of device for preventing the electric shock may be 0.9 mm to 1.1 mm, 0.45 mm to 0.55 mm, and 0.45 mm to 0.55 mm, or 0.55 mm to 0.65 mm, 0.25 mm to 0.35 mm, and 0.25 mm to 0.35 mm, or 0.35 mm to 0.45 mm, 0.15 mm to 0.25 mm, and 0.15 mm to 0.25 mm, respectively. That is, the device for preventing the electric shock may have a ratio of length:width:thickness of 2 to 3:1 to 2:1 to 2. Preferably, length×width×thickness may be 1.0 mm×0.5 mm×0.5 mm, 0.6 mm×0.3 mm×0.3 mm, and 0.4 mm×0.2 mm×0.2 mm. That is, the device for preventing the electric shock may have a ratio of length:width:thickness of 2:1:1. The dimension of the device may be based on the standard for the typical SMT device. Here, the ESD protection layer 320 may have, for example, a width of 50 *µ*m to 500 *µ*m and a thickness of 5 *µ*m to 50 *µ*m according to a size of the device. For example, in the device having the length×width×thickness of 1.0 mm×0.5 mm×0.5 mm, 0.6 mm×0.3 mm×0.3 mm, and 0.4 mm×0.2 mm×0.2 mm, the ESD protection layer 320 may have a width of 50 *µ*m to 450 *µ*m and a thickness of 5 *µ*m to 50 *µ*m.

Also, the device for preventing the electric shock may be variously deformed. Hereinafter, various exemplary embodiments will be described, and descriptions duplicated with the foregoing exemplary embodiment will be omitted.

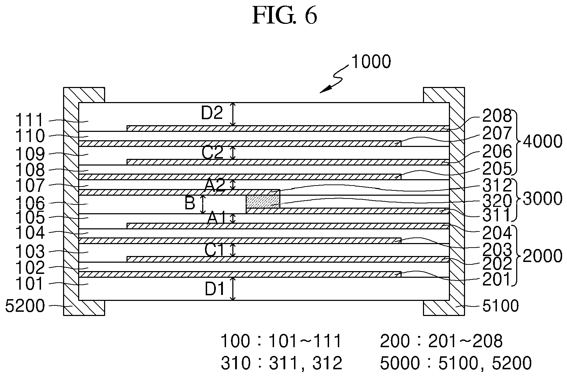

FIG. 6 is a cross-sectional view of a device for preventing an electric shock in accordance with another exemplary embodiment.

Referring to FIGS. 6 to 11, a device for preventing an electric shock in accordance with another exemplary embodiment may include a stacked body 1000 in which a plurality of insulation sheets 100 (101 to 111) are stacked, at least one capacitor part 2000 and 4000 disposed in the stacked body 1000 and including a plurality of internal electrodes 200 (201 to 208), an ESD protection part 3000 including at least one discharge electrode 310 and an ESD protection layer 320, and external electrodes 5000 (5100 and 5200) respectively disposed on two side surfaces facing each other of the stacked body 1000 and connected to the first and second capacitor parts 2000 and 4000 and the ESD protection part 3000.

Here, distances A1 and A2 between the ESD protection part 3000 and the capacitor parts 2000 and 4000 may be less than or equal to that C1 or C2 between the two internal electrodes within each of the capacitor parts 2000 and 4000. That is, each of the fifth and seventh insulation sheets 105 and 107 disposed between the ESD protection part 3000 and each of the capacitor parts 2000 and 4000 may have a thickness less than or equal to that of each of the insulation sheets 102 to 104 and 107 to 110 disposed between the internal electrodes 200 within the capacitor parts 2000 and 4000. Also, the distances A1 AND A2 between the ESD protection part 3000 and the capacitor parts 2000 and 4000 may be less than or equal to that B between the two discharge electrodes 310 of the ESD protection part 3000. That is, each of the fifth and seventh insulation sheets 105 and 107 disposed between the ESD protection part 3000 and each of the capacitor parts 2000 and 4000 may have a thickness less than or equal to that of the sixth insulation sheet 106 on which the ESD protection layer 320 is disposed. As a result, each of the fifth and seventh insulation sheets 105 and 107 disposed between the ESD protection part 3000 and each of the capacitor parts 2000 and 4000 may have a thickness less than or equal to that of each of the insulation sheets 102 to 104 and 107 to 110 disposed between the internal electrodes 200 within the capacitor parts 2000 and 4000 or have a thickness less than or equal to the distance B between the two discharge electrodes 310 of the ESD protection part 3000. That is, the distances A1 and A2 between the ESD protection part 3000 and the capacitor parts 2000 and 4000, the distance C1 and C2 between the two internal electrodes within the capacitor parts 2000 and 4000, and the distance B between the two discharge electrodes 300 of the ESD protection part 3000 may satisfy the following equation: A1=A2≤C1=C2 or A1=A2≤B. Alternatively, the distance A1 may be different from the distance A2, and the distance C1 may be different from the distance C2. The lowermost insulation sheet and the uppermost insulation sheet, i.e., the first and eleventh insulation sheet 101 and 111 may have thickness D1 and D2 that are greater than 10 *µ*m and corresponds to 50% or less of the thickness of the stacked body 1000. Here, the equation may be B≤D1=D2, the thickness D1 may be different from the thickness D2.

Also, in the device for preventing the electric shock in accordance with another embodiment, two internal electrodes adjacent to the discharge electrodes 311 and 312, i.e., the fourth and fifth internal electrodes 204 and 205 may be connected to the discharge electrodes 311 and 312 and the same external electrode. That is, the first, third, fifth, and seventh internal electrodes 201, 203, 205, and 207 may be connected to the second external electrode 5200, and the second, fourth, sixth, and seventh internal electrodes 202, 204, 206, and 208 may be connected to the first external electrode 5100. Also, the first discharge electrode 311 may be connected to the first external electrode 5100, and the second discharge electrode 312 may be connected to the second external electrode 5200. Thus, the first discharge electrode 311 and the fourth internal electrode 204 adjacent to the first discharge electrode 311 may be connected to the first external electrode 5100, and the second discharge electrode 312 and the fifth internal electrode 205 adjacent to the second discharge electrode 312 may be connected to the second external electrode 5200.

As described above, since the discharge electrode 310 and the internal electrode 200 adjacent to the discharge electrode 310 are connected to the same external electrode 5000, although degradation of the insulation sheet 100, i.e., the insulation breakdown occurs, the ESD voltage may not be applied to the inside of the electronic device. That is, when the discharge electrode 310 and the internal electrode 200 adjacent to the discharge electrode 310 are connected the external electrodes 5000 different from each other, if the insulation breakdown of the insulation sheet 100 occurs, the ESD voltage applied through one external electrode 5000 may flow to the other external electrode 5000 through the discharge electrode 310 and the internal electrode 200 adjacent to the discharge electrode 310. For example, as illustrated in FIG. 2, when the first discharge electrode 311 is connected to the first external electrode 5100, and the fourth internal electrode 204 adjacent to the first discharge electrode 311 is connected to the second external electrode 5200, if the insulation breakdown of the insulation sheet 100 occurs, a conductive path may be formed between the first discharge electrode 311 and the fourth internal electrode 204 to allow the ESD voltage applied through the first external electrode 5100 to flow to the first discharge electrode 311, the insulation-broken fifth insulation sheet 105, and the second internal electrode 202. Thus, the ESD voltage may be applied to the internal circuit through the second external electrode 5200. To solve the above-described limitation, although the insulation sheet 100 has a thick thickness, in this case, the device for preventing the electric shock may increase in size. However, as illustrated in FIG. 6, since the discharge electrode 310 and the internal electrode 200 adjacent to the discharge electrode 310 are connected to the same external electrode 5000, although degradation of the insulation sheet 100, i.e., the insulation breakdown occurs, the ESD voltage may not be applied to the inside of the electronic device. Also, although the insulation sheet 100 does not have a thick thickness, the applying of the ESD voltage may be prevented.

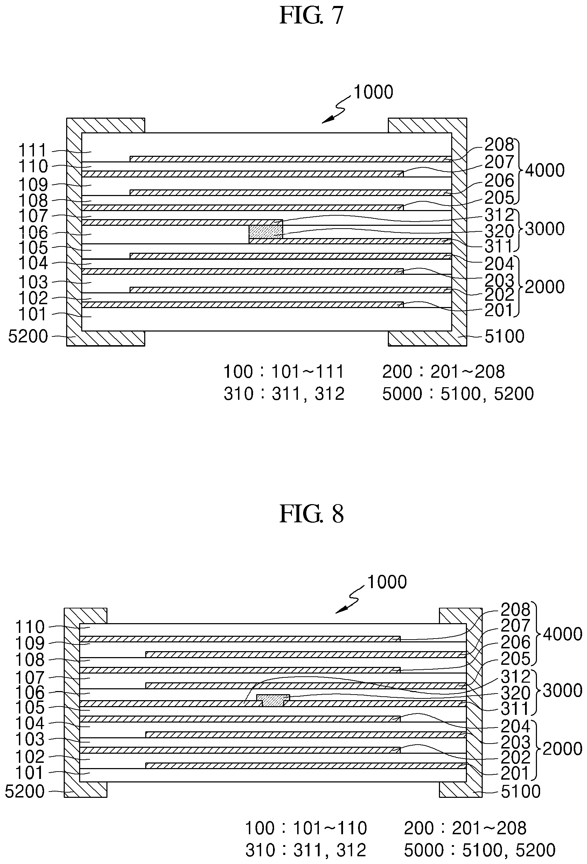

FIG. 7 is a cross-sectional view of a device for preventing an electric shock in accordance with further another exemplary embodiment.

Referring to FIGS. 7 to 11, a device for preventing an electric shock in accordance with further another exemplary embodiment may include a stacked body 1000 in which a plurality of insulation sheets 100 (101 to 111) are stacked, at least one capacitor part 2000 and 4000 disposed in the stacked body 1000 and including a plurality of internal electrodes 200 (201 to 208), an ESD protection part 3000 including at least one discharge electrode 310 and an ESD protection layer 320, and external electrodes 5000 (5100 and 5200) respectively disposed on two side surfaces facing each other of the stacked body 1000 and connected to the first and second capacitor parts 2000 and 4000 and the ESD protection part 3000. Here, the external electrode 5000 may overlap each of the internal electrodes 200 by a predetermined area. That is, the current embodiment may be the same as the foregoing exemplary embodiments except that the external electrode 5000 partially overlaps the internal electrode 200.

The external electrode 5000 may extend to top and bottom surfaces of the stacked body 1000 as well as side surfaces of the stacked body 1000. Also, a predetermined area of the external electrode 5000 may overlap the internal electrode 200 connected to the different external electrode 5000. For example, each of portions of the first external electrode 5100, which extend to upper and lower portions of the stacked, may overlap each of the internal electrodes 200 by a predetermined area. Also, each of portions of the second external electrode 5200, which extend the upper and lower portions of the stacked body 1000, may overlap each of the internal electrodes 200 by a predetermined area. For example, the portions of the external electrodes 5000, which extend to the upper and lower portions of the stacked body 1000, may overlap the first and eighth internal electrodes 201 and 208, respectively. That is, at least one of the external electrodes 5000 may extend to the top and bottom surfaces of the stacked body 1000, and at least one of the extending portions may partially overlap the internal electrode 200. Here, an area of the internal electrode 200, which overlaps the external electrode 5000, may be 1% to 10% of the total area of the internal electrode 200. Also, the external electrode 5000 may increase an area of at least one of the top and bottom surfaces of the stacked body 1000 through a plurality of processes.

To overlap the external electrode 5000, the internal electrode of each of the capacitor parts 2000 and 4000 may be lengthily formed in the X-direction when compared to the case in accordance with an exemplary embodiment. For example, an end of the internal electrode 200 and the external electrode 5000 adjacent to the end may be maintained at a distance of 5% to 10% therebetween in the X-direction. That is, the internal electrode 200 may have a length that corresponds to 90% to 95% of a length of the insulation sheet 100 in the X-direction.

As described above, since the external electrode 5000 and the internal electrode 200 overlap each other, predetermined parasitic capacitance may be generated between the external electrode 5000 and the internal electrode 200. For example, capacitance may be generated between the first and eighth internal electrodes 201 and 208 and the extending portions of the first and second external electrodes 5100 and 5200. Thus, the overlapping area between the external electrode 5000 and the internal electrode 200 may be adjusted to adjust the capacitance of the device for preventing the electric shock. That is, the overlapping area of the external electrode 500 may be adjusted even after the process of manufacturing the device for preventing the electric shock to adjust the capacitance of the device for preventing the electric shock at the outside of the stacked body 1000.

In accordance with the foregoing exemplary embodiments, the ESD protection material is filled into or applied to the through hole formed in the insulation sheet 104 to form the ESD protection layer 320. However, the ESD protection layer 320 may be disposed on a predetermined area of the insulation sheet, and the discharge electrode 310 may be disposed to contact the ESD protection layer 320. That is, as illustrated in a cross-sectional view of FIG. 8 in accordance with further another exemplary embodiment, two discharge electrodes 311 and 312 may be horizontally spaced apart from each other on an insulation sheet 106, and an ESD protection layer 320 may be disposed between the two discharge electrodes 311 and 312.

The ESD protection part 3000 may include at least two discharge electrodes 311 and 312 that are horizontally spaced apart from each other and at least one ESD protection layer 320 disposed between the at least two discharge electrodes 311 and 312. That is, the two discharge electrodes 311 and 312 may be disposed in a direction in which the two discharge electrodes 311 and 312 are spaced apart from each other on a predetermined area, e.g., a central portion of the sheet, i.e., in the X-direction. Also, at least two discharge electrodes (not shown) may be further disposed in directions perpendicular to each other. Thus, at least one discharge electrode may be disposed in a direction perpendicular to that in which the external electrode 5000 is disposed, and at least one discharge electrode may be disposed to be spaced a predetermined distance from each other to face each other. For example, as illustrated in FIG. 8, the ESD protection part 3000 may include a sixth insulation sheet 106, first and second discharge electrodes 311 and 312 spaced apart from each other on the sixth insulation sheet 106, and an ESD protection layer 320 disposed on the sixth insulation sheet 106. Here, the ESD protection layer 320 may have at least a portion connected to the first and second discharge electrodes 311 and 312. The first discharge electrode 311 may be connected to an external electrode 5100 and disposed on the sixth insulation sheet 106 and have an end connected to the ESD protection layer 320. The second discharge electrode 312 be connected to an external electrode 5200 and spaced apart from the first discharge electrode 311 on the sixth insulation sheet 106 and have an end connected to the ESD protection layer 320. The ESD protection layer 320 may be disposed on a predetermined area, e.g., a central portion of the sixth insulation sheet 106 and connected to the first and second discharge electrodes 311 and 312. Here, the ESD protection layer 320 may partially overlap each of the first and second discharge electrodes 311 and 312. The ESD protection layer 320 may be disposed on the sixth insulation sheet 106 that is exposed between the first and second discharge electrodes 311 and 312 and connected to a side surface of each of the first and second discharge electrodes 311 and 312. However, in the case, since the ESD protection layer 320 does not contact the first and second discharge electrodes 311 and 312 without being spaced apart from the first and second discharge electrodes 311 and 312, the ESD protection layer 320 may be disposed to overlap the first and second discharge electrodes 311 and 312.

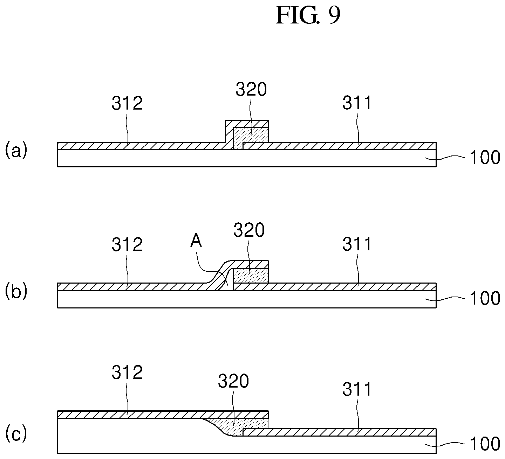

In further another exemplary embodiment, the discharge electrode 310 and the ESD protection layer 320 may be disposed on the same plane and deformed in various shapes. For example, as illustrated in (a) of FIG. 9, a portion of the ESD protection layer 320 may overlap the first discharge electrode 311, and the other portion may contact the insulation sheet 200. That is, the ESD protection layer 320 may be disposed on top and side surfaces of the first discharge electrode 311. Also, the second discharge electrode 312 may contact the top and side surfaces of the ESD protection layer 320 and be disposed on the insulation sheet 200.

Also, as illustrated in FIG. (b) of FIG. 9, the ESD protection layer 320 may contact an upper portion of the first discharge electrode 311, and the second discharge electrode 312 may contact a top surface of the ESD protection layer 320 and be disposed on the insulation sheet 312. Here, a space A may be defined at sides of the second discharge electrode 312, the ESD protection layer 320, and the first discharge electrode 311. That is, the space A may not contact at least the first discharge electrode 311 and second discharge electrode 312. To form the space A, a spacer may be formed on the side surface of the ESD protection layer 320 by using a polymer material before the first discharge electrode 311 is formed. Then, the polymer material may be volatilized in the firing process to form the space A. Alternatively, an insulating material may be formed in the space A, and the ESD protection layer 320 may extend to form the space A.

Also, as illustrated in (c) of FIG. 9, the ESD protection part 3000 may be realized by using the insulation sheet 200 having a stepped portion. That is, the first discharge electrode 311 may be formed in a low region of the insulation sheet 200 of which a portion has a low height when compared to other regions. Then, the ESD protection layer 320 may be formed on the first discharge electrode 311 to remove the stepped portion, and the second discharge electrode 312 may be formed to overlap the ESD protection layer 320 in a high region.

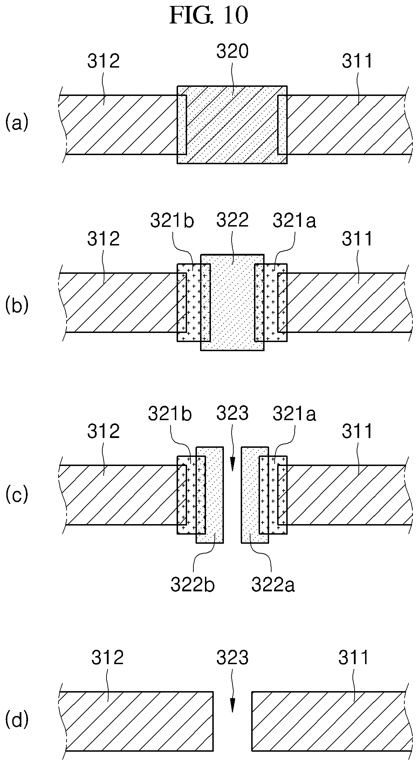

FIG. 10 is a schematic plan view illustrating modified examples of the ESD protection part 3000 in accordance with further another exemplary embodiment.

As illustrated in (a) of FIG. 10, the ESD protection layer 320 may be disposed between the two first and second discharge electrodes 311 and 312 that spaced apart from each other. The ESD protection layer 320 may be formed by mixing a conductive material with an insulating material.

For example, as illustrated in (b) of FIG. 10, a first conductive layer 321a, an insulation layer 322, and a second conductive layer 321b may be horizontally disposed to form the ESD protection layer 320 having a three-layered structure. That is, the first and second conductive layers 321a and 321b may be respectively disposed to contact the first and second discharge electrodes 311 and 312, and the insulation layer 322 may be disposed to be connected between the first and second conductive layers 321a and 321b. However, the ESD protection layer 320 may be formed by using the conductive layer 321 and the insulation layer 322 at least once in a horizontal direction. For example, the ESD protection layer 320 may have a two-layered structure by using the conductive layer 321 and the insulation layer 322. Alternatively, the conductive layer 321, the insulation layer 322, and the conductive layer 321 may be alternately disposed to form a three-layered structure. Also, the conductive layer 321 and the insulation layer 322 may be alternately disposed several times to form at least three-layered structure. Here, a plurality of pores may be formed in at least insulation layer 322. Alternatively, a plurality of pores may be formed in the conductive layer 321.

Also, as illustrated in (c) of FIG. 10, the ESD protection layer 320 may include a first conductive layer 321a, a first insulation layer 322a, a void 323, a second insulation layer 322b, and a second conductive layer 321b between the first and second discharge electrodes 311 and 312. That is, the first and second conductive layers 321a and 321b may be respectively disposed to contact the first and second discharge electrodes 301 and 302, the first and second insulation layers 322a and 322b may be disposed between the first and second conductive layers 321a and 321b, and the void 323 may be formed between the first and second insulation layers 322a and 322b. Alternatively, the conductive layer, the insulation layer, and the void may be repeatedly disposed several times to form the ESD protection layer 320. When the conductive layer 321, the insulation layer 322, and the void 323 are horizontally disposed, the conductive layer 321, the insulation layer 322, and the void 323 may have the same width, or at least one of the conductive layer 321, the insulation layer 322, and the void 323 may have a width less than those of other components. For example, the void 323 may have a width less than that of each of the conductive layer 321 and the insulation layer 322. Also, the conductive layer 321 may have the same width as the insulation layer 322 or have a width greater or less than that of the insulation layer 322. When the insulation layer 322 is formed through a printing process, the void 323 may be formed by forming the insulation layer 322 so that the void 323 is spaced a predetermined distance from the insulation layer 322. Each of the conductive layer 321, the insulation layer 322, and the void 323 may have a width corresponding to 30% to 50% of a width between the first and second discharge electrodes 311 and 312. That is, when at least one of the conductive layer 321, the insulation layer 322, and the void 323 is horizontally disposed, the sum of widths of the conductive layer 321, the insulation layer 322, and the void 323 may be 30% to 50% of the width between the first and second discharge electrodes 311 and 312. The void 323 may be integrally formed between the insulation layers 322. That is, the void 323 may be formed in the insulation layer 322. Alternatively, a plurality of pores within the insulation layer 322 may be connected to each other to form the void 323 in a horizontal or vertical direction.

Alternatively, the ESD protection layer 320 may be formed by using only the void 323. That is, as illustrated in (d) of FIG. 10, the first and second discharge electrodes 311 and 312 may be spaced a predetermined distance from each other, and the void 323 may be formed between the first and second discharge electrodes 311 and 312. Thus, the void 323 may function as the ESD protection layer 320. When the ESD protection layer 320 is formed by using only the void 323, the ESD protection layer 320 may have a width less than that of the ESD protection layer 320 that is formed by using the conductive layer 321, the insulation layer 322, or a mixture thereof.

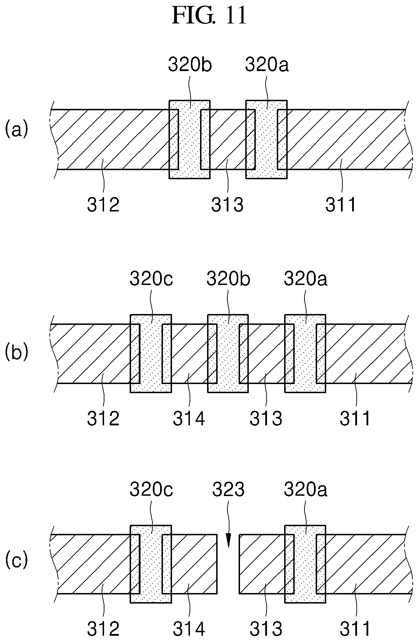

Also, in the device for preventing the electric shock in accordance with further another exemplary embodiment, at least three discharge electrodes of the ESD protection part 3000 may be provided to form at least two ESD protections therebetween. The modified example of the ESD protection part 3000 in accordance with further another exemplary embodiment will be described below with reference to the schematic plan view of FIG. 11.

As illustrated in (a) of FIG. 11, at least three discharge electrodes 311, 312, and 313 that are spaced apart from each other in one direction may be disposed on the same plane, and the ESD protection part 3000 may be disposed between the discharge electrodes adjacent to each other. That is, the first, second, and third discharge electrodes 311, 312, and 313 may be spaced a predetermined distance from each other in one direction, a first ESD protection layer 320a may be disposed between the first and third discharge electrodes 311 and 313, and a second ESD protection layer 320b may be disposed between the third and second discharge electrodes 313 and 312. Here, the first and second ESD protection layers 320a and 320b may be formed of the same material or formed of materials different from each other. For example, each of the first and second ESD protection layers 320a and 320b may be provided as a layer formed of a mixed material of the insulating material and the conductive material. Alternatively, each of the first and second ESD protection layers 320a and 320b may be provided as the conductive layer or the insulation layer. Also, one of the first and second ESD protection layers 320a and 320b may be provided as the conductive layer, and the other layer may be provided as the insulation layer.

Also, as illustrated in (b) of FIG. 11, four discharge electrodes 311, 312, 313, and 314 that are spaced apart from each other in one direction may be disposed on the same plane, and the ESD protection part 320 may be disposed between the discharge electrodes adjacent to each other. That is, the four discharge electrode 311, 312, 313, and 314 may be spaced a predetermined distance from each other in one direction, a first ESD protection layer 320a may be disposed between the first and third discharge electrodes 311 and 313, a second ESD protection layer 320b may be disposed between the third and fourth discharge electrodes 313 and 314, and a third ESD protection layer 320c may be disposed between the fourth and second discharge electrodes 314 and 312. Here, the first to third ESD protection layers 320a, 320b, and 320c may be formed of the same material. For example, each of the first to third ESD protection layers 320a, 320b, and 320c may be provided as a layer formed of a mixed material of the insulating material and the conductive material. Alternatively, each of the first to third ESD protection layers 320a, 320b, and 320c may be provided as the conductive layer or the insulation layer. Also, at least one of the first to third ESD protection layers 320a, 320b, and 320c may be formed of a different material. Also, each of the first and third ESD protection layers 320a and 320c may be provided as the conductive layer, and the second ESD protection layer 320b may be provided as the insulation layer. Alternatively, each of the first and third ESD protection layers 320a and 320c may be provided as the insulation layer, and the second ESD protection layer 320b may be provided as the conductive layer.

Alternatively, at least one of the ESD protection layers 320 may be provided as the void 323. That is, as illustrated in (c) of FIG. 11, four discharge electrode 311, 312, 313, and 314 may be spaced a predetermined distance from each other in one direction, a first ESD protection layer 320a may be disposed between the first and third discharge electrodes 311 and 313, a void 323 may be formed as a second ESD protection layer 320b between the third and fourth discharge electrodes 313 and 314, and a third ESD protection layer 320c may be disposed between the fourth and second discharge electrodes 314 and 312. Here, the first and third ESD protection layers 320a and 320c may be formed of the same material. For example, each of the first and third ESD protection layers 320a and 320c may be provided as a layer formed of a mixed material of the insulating material and the conductive material. Alternatively, each of the first and third ESD protection layer 320a and 320c may be provided as the conductive layer or the insulation layer. Here, the first and third ESD protection layers 320a and 320c may be formed of materials different from each other. For example, one of the first and third ESD protection layers 320a and 320c may be provided as the conductive layer, and the other layer may be provided as the insulation layer.

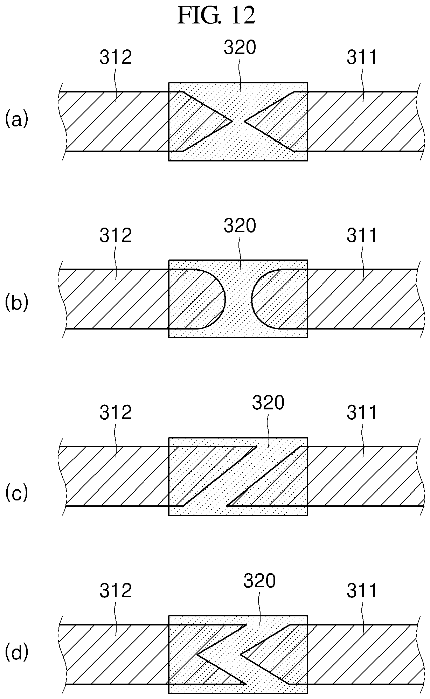

Also, in the device for preventing the electric shock in accordance with an exemplary embodiment, the discharge electrode of the ESD protection part 3000 may be variously deformed in shape. For example, as illustrated in (a) of FIG. 12, each of ends facing each other of the discharge electrodes 311 ad 312 may have a pointed shape. Alternatively, as illustrated in (b) of FIG. 12, each of ends facing each other of the discharge electrodes 311 and 312 may have a rounded shape. That is, a distance between at least one areas of the discharge electrodes 311 and 312 facing each other may be less than that between the other areas of the discharge electrodes 311 and 312. Since each of the ends of the two discharge electrodes 311 and 312 spaced apart from each other is pointed or rounded, a distance between the two discharge electrodes 311 and 312 may approach each other, and thus, discharge between the two discharge electrodes 311 and 312 may well occur.

Also, the two discharge electrodes 311 and 312 may have various shapes while maintaining a distance therebetween. For example, as illustrated in (c) of FIG. 12, one discharge electrode 311 has a predetermined inclination from one side to the other side, and the other discharge electrode 312 has a predetermined inclination in an opposite direction, i.e., from the other side to one side. Also, the discharge electrodes 311 and 312 may have at least one uneven structure while maintaining a distance therebetween. For example, as illustrated in (d) of FIG. 12, an end of one discharge electrode 311 has a concave shape, and an end of the other discharge electrode 312 has a convex shape so that the convex portion is inserted into the concave portion. As described above, since the two internal electrodes have various shapes while maintaining the distance therebetween, an area between the two internal electrodes may increase to improve the ESD tolerance.

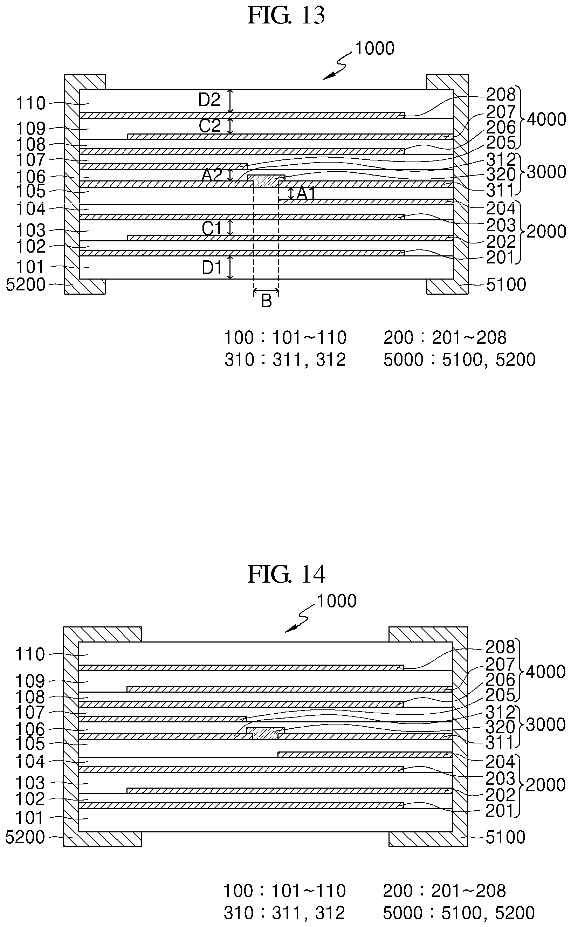

Also, when the ESD protection layer 320 and the discharge electrode 310 are disposed on the same plane, the internal electrodes of the capacitor parts 2000 and 4000 that are adjacent to one discharge electrode 310 may be connected to the same external electrode 5000. Thus, as illustrated in FIG. 13, the first discharge electrode 311 and the fourth internal electrode 204 adjacent to the first discharge electrode 311 may be connected to the first external electrode 5100, and the second discharge electrode 312 and the fifth internal electrode 205 adjacent to the second discharge electrode 312 may be connected to the second external electrode 5200. Here, the fourth internal electrode 204 may have the same length as the first discharge electrode 311, and the fifth internal electrode 205 may have the same length as the second discharge electrode 312. That is, when the fourth internal electrode 204 partially overlaps the second discharge electrode 312, or the fifth internal electrode 205 partially overlaps the first discharge electrode 311, if the insulation breakdown of the insulation sheet 100 occurs, the ESD voltage may flow. Thus, it may be preferable that the internal electrode 200 adjacent tot eh discharge electrode 310 and connected to the same external electrode 5000 has a length equal to or less than that of the discharge electrode 310. Also, even when the discharge electrode 310 and the ESD protection layer are disposed on the same plane, the distance A1 and A2 between the discharge electrode 310 and the adjacent internal electrodes 204 and 205 may be less than or equal to those C1 and C2 between the two internal electrodes of the capacitor parts 2000 and 4000. That is, following equation, which is expressed by A1=A2≤C1=C2, may be satisfied. Alternatively, the distance A1 may be different from the distance A2, and the distance C1 may be different from the distance C2.

Also, as illustrated in FIG. 14, even when the discharge electrode 310 and the ESD protection layer 320 are disposed on the same plane, the external electrode 5000 may partially overlap the internal electrode 200 to adjust the capacitance of the device for preventing the electric shock.

If a chip size decreases, a design space may be reduced. Thus, an inner surface of the device for preventing the electric shock, which has high ESD resistance in a narrow space, is needed. However, when the device for preventing the electric shock is reduced in size, the insulation sheet may be thinner due to space shortage. Thus, the resistance property of the insulation sheet in itself may be reduced to prevent the insulation resistance of the insulation sheet from being broken even though the ESD having a low level is applied. To solve the above-described limitation, a floating type structure having various shapes may be used to improve the ESD resistance property within the same space when compared to the general tacking type structure. That is, since the internal electrode of the capacitor part is deformed in shape to increase the thickness of the insulation sheet twice or more in one region between the internal electrodes, the ESD resistance property may be maintained. Thus, the ESD resistance property may be more improved associated with the design of the ESD protection part of the device for preventing the electric shock. As a result, when the ESD is not bypassed to the ESD protection part due to the deterioration in function by the repeated ESD voltage of the ESD protection part, the capacitor part may be damaged to cause the insulation breakdown. Also, although the function of the ESD protection part is not deteriorated, when the ESD voltage is introduced, an ESD voltage load may temporarily occur in the capacitor part during the period of blank of 1 ns to 30 ns till the reaction time of the ESD protection part of the device for preventing the electric shock to cause the insulation breakdown. However, the capacitor part may be provided as the floating type to increase the ESD resistance property of the capacitor layer, thereby preventing the phenomenon in which the insulation resistance is broken to cause the short circuit from occurring.

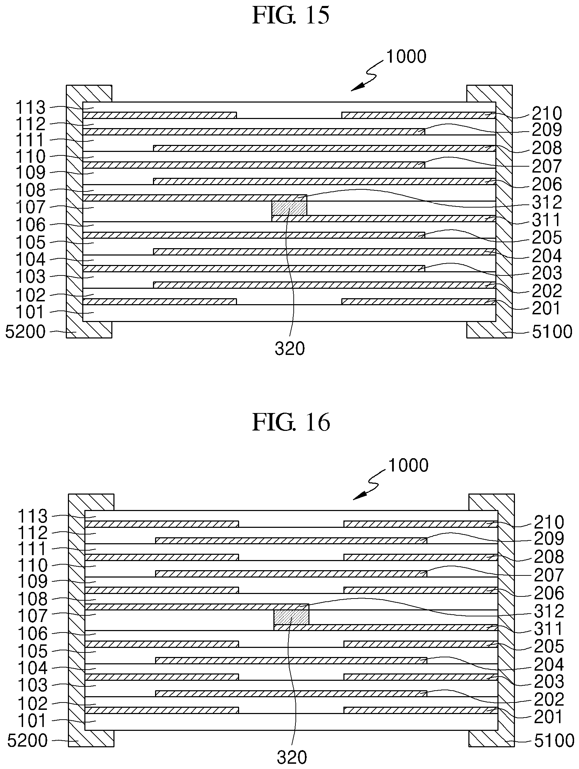

The floating type capacitor part in accordance with various exemplary embodiments will be described with reference to FIGS. 15 to 18.

Referring to FIGS. 15 to 18, a device for preventing an electric shock in accordance with further another exemplary embodiment may include s stacked body 1000 on which a plurality of insulation sheets 100 (101 to 103) are stacked. A first capacitor part 2000, an ESD protection part 3000, and a second capacitor part 4000 may be provided in the stacked body 1000. Also, the device for preventing the electric shock may further include external electrodes 5000 (5100 and 5200) disposed on two side surfaces facing each other of the stacked body 1000 to connect the first and second capacitor parts 2000 and 4000 to an ESD protection part 3000. The first capacitor part 2000 may include a plurality of internal electrodes 201 to 205, and the second capacitor part 400 may include a plurality of internal electrodes 208 to 212. That is, each of the first and second capacitor parts 2000 and 4000 may include the same number of internal electrodes, e.g., five internal electrodes. Also, the ESD protection part 3000 including discharge electrodes 311 and 312 between the first and second capacitor parts 2000 and 4000 and an ESD protection layer 320 disposed between the discharge electrodes 311 and 312 are provided. Here, each of the first and second capacitor parts 2000 and 4000 may include at least one internal electrode having a shape of which at least one region is removed.

As illustrated in FIG. 15, the internal electrode 201 of the first capacitor part 2000 may have a shape of which a central portion is removed by a predetermined width, and the internal electrode 210 of the second capacitor part 4000 that is symmetrically disposed with the ESD protection part 3000 between the first and second capacitor parts 2000 and 4000 may also have a shape of which a predetermined region at the same position as the internal electrode 201 is removed. Since the predetermined region of each of the internal electrodes 201 and 210 is removed, an overlapping area between the internal electrodes 202 and 209 that are respectively adjacent to the internal electrodes 201 and 210 may be reduced. Here, the internal electrodes 201 and 210 that are divided into two parts by removing the predetermined region may be connected to the first and second external electrodes 5100 and 5200, respectivley. As described above, since each of the internal electrodes 201 and 210 has the shape of which the predetermined region is removed, each of the insulation sheets 102 and 112 between the internal electrodes 201 and 210 and the internal electrodes 202 and 209 adjacent to the internal electrodes 201 and 210 may be thicker. That is, since the two insulation sheets 101 and 102 are disposed between the removed portions of the internal electrodes 202 and 210, the insulation sheet 100 may increase in thickness. Thus, since the insulation sheet 100 increases at least twice in one region between the internal electrodes 200 of the capacitor parts 2000 and 4000, an ESD resistance property may be maintained.

Also, illustrated in FIG. 16, predetermined regions of central portions of internal electrodes 201, 203, and 205 of the first capacitor part 2000 may be removed, and predetermined regions of central portions of internal electrodes 206, 208, and 210 of the second capacitor part 4000 that is symmetrically disposed with an ESD protection part 3000 between the first and second capacitor parts 2000 and 4000 may be removed. Here, the internal electrodes 202, 204, 207, and 209 may not contact the external electrode 5000 to overlap at least a portion of each of the internal electrodes 201, 203, 205, 206, 208, and 210 between the internal electrodes 201, 203, 205, 206, 208. That is, the internal electrodes 202, 204, 207, and 209 may disposed on the central portions of the insulation sheet 100 to overlap the internal electrodes 201, 203, 205, 206, 208, and 210, which are not disposed at the central portion of the insulation sheet 100.

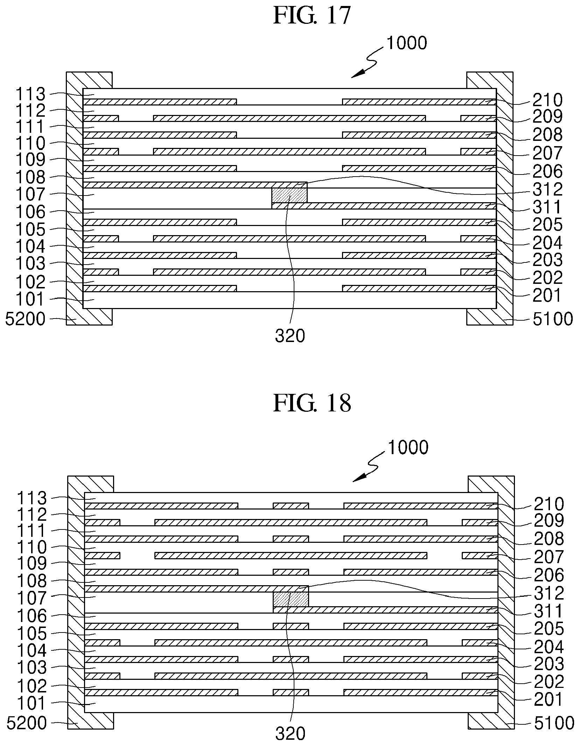

Also, in each of the internal electrodes of the first and second capacitor parts 2000 and 4000, a region that is spaced a predetermined distance from the central region as well as the central region may be removed. For example, as illustrated in FIG. 17, the central regions of the internal electrodes 210, 203, and 204 of the first capacitor 2000 may be removed, and removed portions of the internal electrodes 202 and 204 disposed between the internal electrodes 210, 203, and 205 may be disposed at both sides which are spaced a predetermined distance from the central regions. Also, in the second capacitor part 4000, central regions of internal electrodes 206, 208, and 210 which are disposed symmetrical to the internal electrodes 210, 203, and 205 of the first capacitor part 2000 with the ESD protection part 3000 therebetween may be removed. Also, removing regions of the internal electrodes 207 and 209 disposed between the internal electrodes 206, 208, and 210 may be formed at the same positions as the internal electrodes 202 and 204 of the first capacitor part 2000.

Also, as illustrated in FIG. 18, at least two removing regions may be formed at the central regions of the internal electrodes 201, 203, and 205 of the first capacitor part 2000, and removing regions of the internal electrodes 202 and 204 disposed between the internal electrodes 201, 203, and 205 may be formed at both sides thereof, each of which is spaced a predetermined distance from each of the central regions. Also, in the second capacitor part 4000, at least two removing region may be formed at central regions of internal electrodes 206, 208, and 210 which are disposed symmetrical to the internal electrodes 210, 203, and 205 of the first capacitor part 2000 with the ESD protection part 3000 therebetween. Also, removing regions of the internal electrodes 207 and 209 disposed between the internal electrodes 206, 208, and 210 may be formed at the same positions as the internal electrodes 202 and 204 of the first capacitor part 2000.

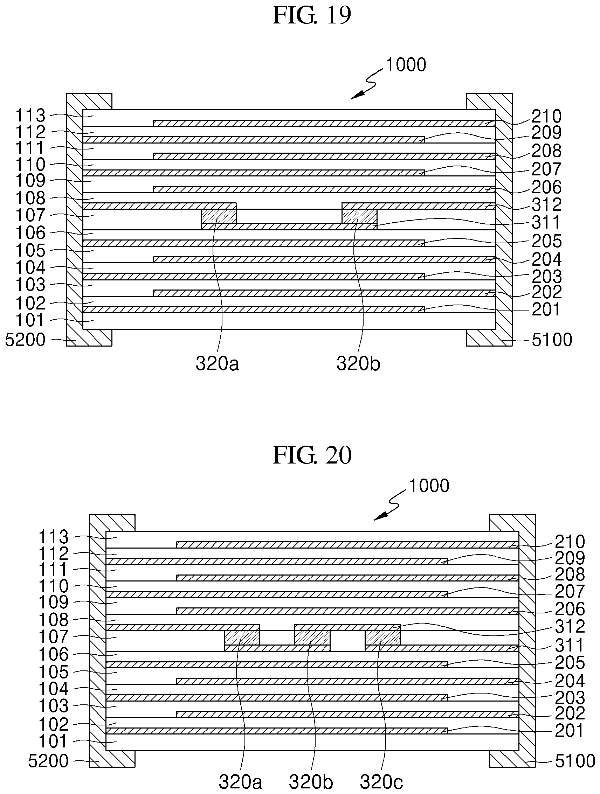

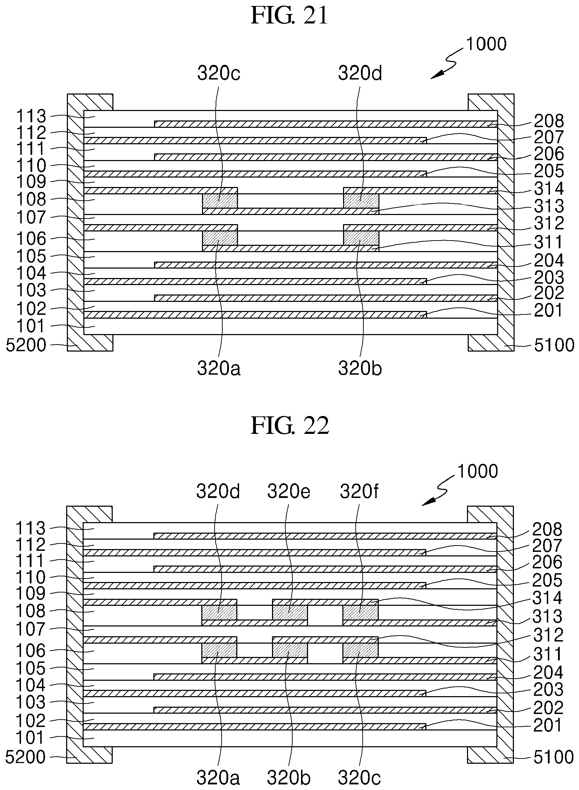

The device for preventing the electric shock in accordance with exemplary embodiments may include at least one ESD protection layer 320 of the ESD protection part 3000. That is, as illustrated in FIGS. 2, 6, 7, and 8, one ESD protection layer 300 may be disposed in the X-direction. As illustrated in FIGS. 19 to 22, at least two ESD protection layers 320 may be disposed in the X-direction. Here, a plurality of ESD protection layers 320 may be disposed in the Y-direction. For example, as illustrated in FIG. 19, two ESD protection layers 320a and 320b may be disposed on the same plane. As illustrated in FIG. 20, three ESD protection layers 320a, 320b, and 320c may be disposed on the same plane. At least two ESD protection layers 320a, 320b, and 320c may be connected to each other through an internal electrode. Also, as illustrated in FIG. 21, four ESD protection layers 320a, 320b, 320c, and 320d may be vertically divided into two groups of two ESD protection layers. As illustrated in FIG. 22, six ESD protection layers 320a, 320b, 320c, 320d, 320e, and 320f may be vertically divided into three groups of two ESD protection layers. In the ESD protection layers 320 that are vertically spaced apart from each other, upper ESD protection layers may be connected to each other, and lower ESD protection layers may be connected to each other. When the plurality of ESD protection layers 320 are provided, the ESD protection layers 320 may have the same structure or structures different from each other.

As described above, the device for preventing the electric shock in accordance with an exemplary embodiment may include at least one capacitor part 2000 and 4000 and at least one ESD protection part 3000 within one stacked body. For example, one capacitor part and at least two ESD protection parts may be provided. Here, the capacitor part may be disposed between the internal circuit and the metal case, and the ESD protection parts may be disposed between the capacitor part and the ground terminal. For this, the first and second external electrodes 5100 and 5200 are disposed on two side surfaces facing each other of the stacked body, and third and fourth external electrodes (not shown) may be disposed on two side surfaces facing each other, on which the first and second external electrodes 5100 and 5200 are not disposed. Each of the first and second external electrodes 5100 and 5200 may be disposed between the metal case and the internal circuit of the electronic device, and each of the third and fourth external electrodes may be connected to the ground terminal. That is, the first and second external electrodes 5100 and 5200 may be respectively disposed in two regions between the metal case and the internal circuit of the electronic device, and the third and fourth external electrodes may be connected to the ground terminal.

Also, the device for preventing the electric shock in accordance with an exemplary embodiment may include a plurality of capacitor parts 2000 and 4000 and a plurality of ESD protection parts 3000, which are horizontally disposed in the stacked body 1000. That is, at least one capacitor part 2000 and 4000 and an ESD protection part 3000, which are vertically stacked, may be horizontally arranged in at least two rows and connected to at least two external electrodes 5000 that are horizontally arranged. Thus, the plurality of devices for preventing the electric shock, each of which includes the plurality of capacitor parts and ESD protection parts may be disposed parallel to each other. Therefore, at least two devices for preventing the electric shock may be provided in one stacked body 1000. Here, for example, the plurality of first external electrodes 5100 may be connected to a plurality of areas of the metal case of the electronic device, and the plurality of second external electrodes 5200 may be connected to the ground terminal of the electronic device. In the plurality of capacitor parts, at least one internal electrode may have a different length. That is, at least one internal electrode of the plurality of internal electrodes that are horizontally disposed to respectively constitute capacitor parts different from each other may have a length less than that of the other internal electrode. Also, at least one of an overlapping area of the internal electrodes and the stacked numbers of internal electrodes in addition to the length of the internal electrode may be adjusted to adjust the capacitance. Thus, at least one of the plurality of capacitor parts may have a different capacitance. That is, at least one capacitor part within one stacked body may realize the plurality of capacitor parts having capacitances different from each other.

Results according to various experimental examples of the device for preventing the electric shock in accordance with an exemplary embodiment will be described as follows.

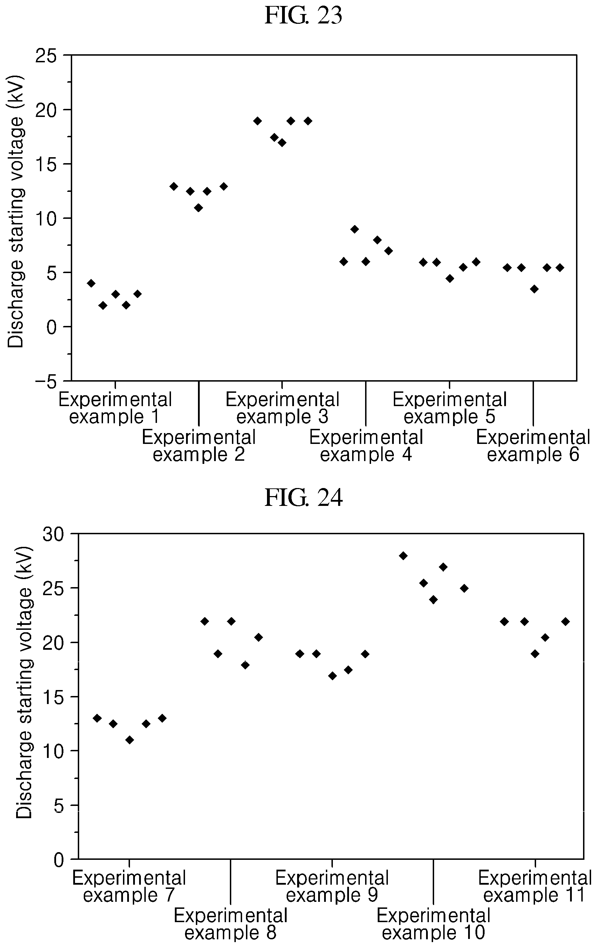

Table 1 is illustrates characteristics in accordance with a structure of an ESD protection layer, and FIG. 23 is a view illustrating discharge starting voltages in accordance with the characteristics. That is, FIG. 23 illustrates a discharge starting voltage in accordance with a thickness of the ESD protection layer, thicknesses of a conductive layer A and an insulation layer B, a pore size and porosity of the insulation layer, and a structure of the ESD protection layer.

**[Table 1]**

| Experim ental example | Thickness (*µ*m) of ESD protection layer | Thickness (*µ*m) of conductive layer | Thickness (*µ*m) of insulation layer | Pore size of insulation layer | Porosity of insulation layer | Thicknes s (*µ*m) of void | Discharge starting voltage (kV) | Short occurrence rate |
|---|---|---|---|---|---|---|---|---|
| 1 | 25 | 25 | 0 | - | - | - | 2∼4 | 100% |
| 2 | 10 | 0 | 10 | 1 nm∼5 *µ*m | 40% | - | 12.4 (11∼13) | 0.8% |
| 3 | 25 | 0 | 25 | 1 nm∼5 *µ*m | 40% | - | 18.3 (17∼19) | 0% |
| 4 | 25 | 15 | 10 | 1 nm∼5 *µ*m | 40% | - | 7.2(6∼9) | 0% |
| 5 | 25 | 8 | 5 | 1 nm∼5 *µ*m | 40% | - | 5.6(4∼6) | 0% |
| 6 | 25 | 8 | 2 | 1 nm∼5 *µ*m | 40% | 3 | 5.1(3∼5.5) | 0% |

In Experimental example 1, an ESD protection layer having a thickness of 25 *µ*m was formed by using only a conductive layer (conductive ceramic). In Experimental example 2, an ESD protection layer having a thickness of 10 *µ*m was formed by using only an insulation layer (insulating ceramic). In Experimental example 3, an ESD protection layer having a thickness of 25 *µ*m was formed by using only the insulation layer. Also, in Experimental example 4, the conductive layer and the insulation layer were stacked to form an ESD protection layer having a thickness of 25 *µ*m. In Experimental example 5, the conductive layer, the insulation layer, and the conductive layer were stacked to form an ESD protection layer having a thickness of 25 *µ*m. In Experimental example 5, the conductive layer and the insulation layer have thicknesses of 8 *µ*m and 5 *µ*m, respectively. Also, in Experimental example 6, the conductive layer, the insulation layer, an air gap, the insulation layer, and the conductive layer were stacked to form an ESD protection layer having a thickness of 25 *µ*m. Here, the conductive layer, the insulation layer, and the void have thicknesses of 8 *µ*m, 2 *µ*m, and 3 *µ*m, respectively. In Experimental examples 2 to 6, the insulation layer has a pore size of 1 nm to 5 *µ*m, and thus, the insulation layer has a porosity of 40%. That is, pores having various sizes of 1 nm to 5 *µ*m are formed in the insulation layer.

As shown in Table 1, a plurality of experiments with respect to Experiment example 1 in which the ESD protection layer is formed by using only the conductive layer were conducted. Here, the discharge starting voltage is approximately 2 kV to approximately 4 kV, and the short circuit of 100% occurs. That is, in Experimental example 1, the discharge starting voltage of a plurality of samples is distributed to a voltage of 2 kV to 4 kV. All the samples are insulation-broken to cause leakage current. Also, in Experimental example 2 in which the ESD protection layer having the thickness of 10 *µ*m is performed by using only the insulation layer, the discharge starting voltage is approximately 11 kV to approximately 13 kV, and the short circuit of approximately 0.8% occurs. However, in Experimental examples 3 to 6 in which the conductive layer and the insulation layer or the void are stacked to form the ESD protection layer, the discharge starting voltage is adjusted to a voltage of 3 kV to 19 kV, an short circuit does not occur. That is, the discharge starting voltage in Experimental examples 4 to 6 is less than that in Experimental example 2, but the insulation breakdown does not occur due to the structural difference. The discharge starting voltages in accordance with Experimental examples are illustrated in FIG. 22.

As shown in Table 1, the insulation layer may be provided to reduce possibility of an occurrence of the short circuit due to the insulation breakdown. Also, the conductive layer may be provided to reduce the thickness of the insulation layer and improve the discharge starting voltage. Also, when the void is added while reducing the thickness the insulation layer, the discharge starting voltage may decrease to reduce the possibility of the occurrence of the short circuit.

Table 2 illustrates characteristics in accordance with a variation in thickness and porosity of the insulation layer, and FIG. 23 is a view illustrating discharge start voltages in accordance with the characteristics. The porosity is set to 40% and 1% or less, and the pore size is 1 nm to 5 *µ*m in case of the porosity of 40% and is 0 in case of the porosity of 1% or less. That is, characteristics when the pore is formed in the insulation layer and when the pore is not formed in the insulation layer may be compared and shown in Table 2.

**[Table 2]**

| Experim ental example | Thickness (*µ*m) of ESD protection layer | Thickness (*µ*m) of conductive ceramic | Thickness (*µ*m) of insulating ceramic | Pore size of insulating ceramic | Porosity of insulating ceramic | Thicknes s (*µ*m) of void | Discharge starting voltage (kV) | Short occurrenc e rate |
|---|---|---|---|---|---|---|---|---|
| 7 | 10 | 0 | 10 | 1 nm∼5 *µ*m | 40% | - | 12.4 (11∼13) | 0.9% |
| 8 | 10 | 0 | 10 | 0 | ∼1% | - | 20.3 (18∼22) | 3.5% |
| 9 | 25 | 0 | 25 | 1 nm∼5 *µ*m | 40% | - | 18.3 (17∼19) | 0% |
| 10 | 25 | 0 | 25 | 0 | ∼1% | - | 20.5 (24∼28) | 0% |
| 11 | 25 | 0 | 25 | 1 nm∼5 *µ*m | 80% | - | 21.1 (19∼22) | 0% |

In Experimental examples 7 and 8, the insulation layer has a thickness of 5 *µ*m and porosities of 40% and 1% or less. Also, in Experimental examples 9 and 10, the insulation layer has a thickness of 25 *µ*m and porosities of 40% and 1% or less. Also, in Experimental example 11, the insulation layer has a thickness of 25 *µ*m and a porosity of 40%. As shown in Experimental examples 7 and 8, the ESD protection layer has a thickness of 10 *µ*m. Thus, when the insulation layer has a thickness of 10 *µ*m, the porosity of the insulation layer is recued to increase the discharge starting voltage and the possibility of the occurrence of the short circuit. Also, as shown in Experimental examples 9 and 10, the ESD protection layer has a thickness of 25 *µ*m. Thus, when the insulation layer has a thickness of 25 *µ*m, the porosity of the insulation layer is reduced to increase the discharge starting voltage. However, since the insulation layer increases in thickness, the short circuit does not occur. As shown in Experimental example 11, when the insulation layer has a thickness of 25 *µ*m, and the porosity increases to 80%, the discharge starting voltage is approximately 21.1 kV. The discharge starting voltage in accordance with Table 2 is illustrated in FIG. 23.

Table 3 illustrates characteristics in accordance with the pore size of the insulation layer, and FIG. 24 is a view illustrating discharge starting voltages in accordance with the characteristics. That is, when the ESD protection layer has a thickness of 25 *µ*m, and thus, the insulation layer has a thickness of 25 *µ*m, the discharge starting voltage in accordance with the pore size of the insulation layer is expressed.

**[Table 3]**

| Experim ental example | Thickness (*µ*m) of ESD protection layer | Thickness (*µ*m) of conductive ceramic | Thickness (*µ*m) of insulating ceramic | Pore size of insulating ceramic | Porosity of insulating ceramic | Thicknes s (*µ*m) of void | Discharge starting voltage (kV) | Short occurrence rate |
|---|---|---|---|---|---|---|---|---|
| 12 | 25 | 0 | 25 | 1 nm~5 *µ*m | 40% | - | 18.3 (17∼19) | 0% |
| 13 | 25 | 0 | 25 | 5 nm~10 *µ*m | 40-60% | - | 19.7 (18∼20.5) | 0% |
| 14 | 25 | 0 | 25 | 0 | ∼1% | - | 25.9 (24∼28) | 0% |

In Experimental example 12, the insulation layer has a pore size of 1 nm to 5 *µ*m, and thus, the insulation layer has a porosity of 40%. Also, in Experimental example 13, the insulation layer has a pore size of 5 nm to 10 *µ*m, and thus, the insulation layer has a porosity of 40% to 60%. Also, in Experimental example 14, the insulation layer has a pore size of 0, and thus, the insulation layer has a porosity of 1% or less. As shown in Table 3 and FIG. 24, the discharge starting voltage is approximately 17 kV to approximately 19 kV and thus has a mean value of approximately 18.3 kV in case of Experimental example 12. In case of Experimental example 13, the discharge starting voltage is approximately 18 kV to approximately 20.5 kV and thus has a mean value of approximately 19.7 kV. That is, as the pore size increases, the discharge starting voltage increases. Also, in case of Experimental example 14, the discharge starting voltage is approximately 24 kV to approximately 28 kV and thus has a mean value of approximately 25.9 kV. That is, as shown in Experimental example 14, when the ESD protection layer is formed by using the insulation layer in which the pore is not formed, a high discharge starting voltage is obtained. However, in this case, the short circuit does not occur.

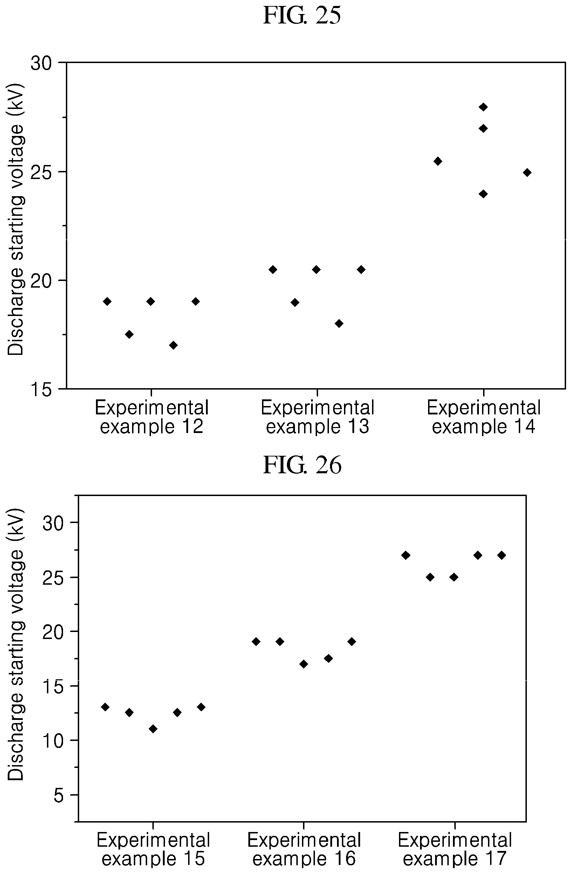

Table 4 illustrates characteristics in accordance with the thickness of the ESD protection layer, and FIG. 25 is a view illustrating discharge starting voltages in accordance with the characteristics. That is, when the thickness of the ESD protection layer is adjusted to thicknesses of 10 *µ*m, 25 *µ*m, and 50 *µ*m, and thus, the thickness of the insulation layer is adjusted to thicknesses of 10 *µ*m, 25 *µ*m, and 50 *µ*m, the discharge starting voltage in accordance with the thicknesses of the ESD protection layer is expressed. Here, the insulation layer has a pore size of 1 nm to 5 *µ*m and a porosity of 40%.

**[Table 4]**

| Experim ental example | Thickness (*µ*m) of ESD protection layer | Thickness (*µ*m) of conductive ceramic | Thickness (*µ*m) of insulating ceramic | Pore size of insulating ceramic | Porosity of insulating ceramic | Thicknes s (*µ*m) of void | Discharg e starting voltage (kV) | Short occurrence rate |
|---|---|---|---|---|---|---|---|---|
| 15 | 10 | 0 | 10 | 1 nm∼5 *µ*m | 40% | - | 12.4 (11∼13) | Occurrence of short circuit of 0.9% |
| 16 | 25 | 0 | 25 | 1 nm∼5 *µ*m | 40% | - | 18.3 (17∼19) | 0% |
| 17 | 50 | 0 | 50 | 1 nm~5 *µ*m | 40% | - | 26.2 (25∼27) | 0% |

In Experimental example 15, the ESD protection layer has a thickness of 10 *µ*m, and thus, the insulation layer has a thickness of 10 *µ*m. In Experimental example 16, the ESD protection layer has a thickness of 25 *µ*m, and thus, the insulation layer has a thickness of 25 *µ*m. In Experimental example 17, the ESD protection layer has a thickness of 50 *µ*m, and thus, the insulation layer has a thickness of 50 *µ*m. As shown in Table 4 and FIG. 8, the discharge starting voltage is approximately 11 kV to approximately 13 kV (a mean value of 12.4 kV) in case of Experimental example 15. In case of Experimental example 16, the discharge starting voltage is approximately 17 kV to approximately 19 kV (a mean value of 18.3 kV). In case of Experimental example 17, the discharge starting voltage is approximately 25 kV to approximately 27 kV (a mean value of 26.2 kV). As shown in Experimental examples 15 to 17, when the ESD protection increases in thickness, and thus, the insulation layer increases in thickness, the discharge starting voltage increases. However, in case of Experimental example 15 in which the ESD protection layer has a thickness 10 *µ*m, the short circuit of approximately 0.9% occurs.

Table 5 illustrates an occurrence of the short circuit in accordance with the overlapping area of the internal electrodes of the capacitor part. Here, ten internal electrodes of the capacitor part overlap each other, the insulation sheet has a thickness of 25 *µ*m, and the applied ESD voltage is 10 kV.

**[Table 5]**

| Experim ental example | Thicknes s (*µ*m) of insulation sheet | Stacked number of capacitor part | Overlappin g area of internal electrode | ESD level | ESD repetition apply short occurrence time point (mean) | ESD pass/unit overlapping area (mean) |
|---|---|---|---|---|---|---|
| 18 | 25 | 10 | 1.2mm² | | 362.00 times | 301.67 times/mm² |
| 19 | 25 | 10 | 1.0mm² | 10kV | 313.48 times | 313.48 times/mm² |
| 20 | 25 | 10 | 0.8mm² | | 267.62 times | 334.53 times/mm² |
| 21 | 25 | 10 | 0.8mm² | | 275.04 times | 343.85 times/mm² |
| 22 | 25 | 10 | 0.8mm² | | 299.04 times | 373.80 times/mm² |

In Experimental example 18, the total overlapping area of the internal electrodes is 1.2 mm². In Experimental example 19, the total overlapping area of the internal electrodes is 1.0 mm². In Experimental example 20, the total overlapping area of the internal electrodes is 0.8 mm². In Experimental examples, when the ESD voltage of 10 kV is applied, as shown in Table 5, a mean short occurrence time point decreases as the total overlapping area decreases. However, a mean value of ESD pass numbers per a unit overlapping area decreases as the overlapping area decreases. Thus, even though the overlapping area of the internal electrodes decreases, the ESD pass numbers per the unit overlapping area may increase. Thus, even though the chip size decreases, the ESD resistance property may be maintained.

Tables 6 and 7 illustrate test results in accordance with the thickness of the dielectric layer depending on the dielectric constant of the sheets and the repeated applying of the ESD voltage. Table 6 illustrates test results when a dielectric having a dielectric constant of 75 has a thickness of 5 *µ*m to 30 *µ*m, and an ESD voltage of 10 kV is repeatedly applied, and Table 8 illustrates test results when a dielectric having a dielectric constant of 2900 has a thickness of 5 *µ*m to 30 *µ*m, and an ESD voltage of 10 kV is repeatedly applied.

**[Table 6]**

| | 10 times | 20 times | 40 times | 60 times | 80 times | 100 times | 120 times | 140 times | Result |
|---|---|---|---|---|---|---|---|---|---|
| 5 *µ*m | 2/10 | | | | | | | | Fail |
| 10 *µ*m | Ok | Ok | 3/10 | | | | | | Fail |
| 15 *µ*m | Ok | Ok | Ok | Ok | 2/10 | | | | Fail |
| 20 *µ*m | Ok | Ok | Ok | Ok | Ok | Ok | 1/10 | | Pass |
| 25 *µ*m | Ok | Ok | Ok | Ok | Ok | Ok | Ok | Ok | Pass |
| 30 *µ*m | Ok | Ok | Ok | Ok | Ok | Ok | Ok | Ok | Pass |

As shown in Table 6, if an ESD voltage of 10 kV is applied to a dielectric having a dielectric constant of 75, when the ESD voltage is applied 10 times at a thickness of 5 *µ*m, two fails occur, and when the ESD voltage is applied 40 times at a thickness of 10 *µ*m, three fails occur. Also, when the ESD voltage is applied 80 times at a thickness of 15 *µ*m, two fails occur, and when the ESD voltage is applied 120 times at a thickness of 20 *µ*m, one fail occurs. Thus, when the ESD voltage of 10 kV is applied 80 times, the desired capacitance and ESD property may be obtained at a thickness of 15 *µ*m.

**[Table 7]**

| | 10 times | 20 times | 40 times | 60 times | 80 times | 100 times | 120 times | 140 times | Result |
|---|---|---|---|---|---|---|---|---|---|
| 5 *µ*m | 3/10 | | | | | | | | Fail |
| 10 *µ*m | Ok | Ok | 1/10 | | | | | | Fail |
| 15 *µ*m | Ok | Ok | Ok | Ok | 4/10 | | | | Fail |
| 20 *µ*m | Ok | Ok | Ok | Ok | Ok | Ok | 3/10 | | Pass |
| 25 *µ*m | Ok | Ok | Ok | Ok | Ok | Ok | Ok | Ok | Pass |
| 30 *µ*m | Ok | Ok | Ok | Ok | Ok | Ok | Ok | Ok | Pass |

As shown in Table 7, if an ESD voltage of 10 kV is applied to a dielectric having a dielectric constant of 2900, when the ESD voltage is applied 10 times at a thickness of 5 *µ*m, two fails occur, and when the ESD voltage is applied 40 times at a thickness of 10 *µ*m, one fail occurs. Also, when the ESD voltage is applied 80 times at a thickness of 15 *µ*m, four fails occur, and when the ESD voltage is applied 120 times at a thickness of 20 *µ*m, three fail occur. Thus, when the ESD voltage of 10 kV is applied 80 times, the desired capacitance and ESD property may be obtained at a thickness of 15 *µ*m.

The device for preventing the electric shock in accordance with the exemplary embodiments may be disposed between the metal case and the internal circuit of the electronic device to block the electric shock voltage transmitted from the ground terminal of the internal circuit. Thus, the electric shock voltage generated in the faulty charger may be prevented from being transmitted from the ground terminal within the electronic device to the user through the metal case. Also, the device for preventing the electric shock may include the ESD protection part, and the ESD protection part may have the porous structure to allow the current to flow through the fine pores. Thus, the introduced ESD may be bypassed to the ground terminal to maintain the insulated state of the device. Therefore, the electric shock voltage may be continuously blocked, and the ESD voltage applied from the outside may be bypassed to the ground terminal.

Also, the external electrode may overlap at least a portion of the internal electrode by the predetermined area. Thus, the predetermined parasitic capacitance may be generated between the external electrode and the internal electrodes. Also, the overlapping area between the external electrode and the internal electrode may be adjusted to adjust the capacitance of the device for preventing the electric shock.

Also, the discharge electrode of the ESD protection part and the internal electrode of the capacitor part that is adjacent to the discharge electrode may be connected to the same external electrode. Therefore, although the insulation sheet is insulation-broken, the applying of the ESD voltage may be prevented.

The present invention may, however, be embodied in different forms and should not be construed as limited to the embodiments set forth herein. Rather, these embodiments are provided so that this disclosure will be thorough and complete, and will fully convey the scope of the present invention to those skilled in the art. Further, the present invention is only defined by scopes of claims.

## Claims

1. A device for preventing an electric shock, the device comprising:
a stacked body in which a plurality of insulation sheets are stacked;
a capacitor part comprising a plurality of internal electrodes disposed in the stacked body;
an ESD protection part disposed on at least a portion of each of the insulation sheets to protect an ESD voltage; and
an external electrode disposed on each of at least two side surfaces outside the stacked body and connected to the capacitor part and the ESD protection part,
wherein the ESD protection part comprises at least two or more discharge electrodes and at least one ESD protection layer disposed between the discharge electrodes, and
one of the external electrodes is connected to a metal case of an electronic device, and the other one of the external electrodes is connected to a ground terminal to block an electric shock voltage and bypass the ESD voltage.

2. The device of claim 1, wherein the ESD protection layer comprises a porous insulating material, a conductive material, and a void, and
the void is formed by connecting at least two voids of the insulating materials adjacent to each other.

3. The device of claim 2, wherein the discharge voltage is less than a discharge starting voltage, and the ESD voltage is greater than the discharge starting voltage.

4. The device of claim 2, wherein the discharge electrode and the ESD protection layer are respectively disposed on planes different from each other or are disposed on the same plane.

5. The device of claim 4, wherein the discharge electrode and the internal electrode adjacent to the discharge electrode are connected to the same external electrode.

6. The device of claim 4, wherein the discharge electrode and the internal electrode adjacent to the discharge electrode are connected to the external electrodes different from each other.

7. The device of claim 5 or 6, wherein, when a distance between the discharge electrode and the internal electrode adjacent to the discharge electrode is A, a distance between the discharge electrodes is B, and a distance between the internal electrodes is C, A≤C or A≤B is satisfied.

8. The device of claim 7, wherein, when the uppermost and lowermost insulation sheets have thickness D1 and D2, B≤D1 and B≤D2 are satisfied, and D1 is equal to or different from D2.

9. The device of claim 8, wherein each of the uppermost and lowermost insulation sheets has a thickness that is equal to or greater than 10 *µ*m and equal to or less than 50% of a thickness of the stacked body.

10. The device of claim 7, wherein the discharge electrode has the same thickness as the internal electrode.

11. The device of claim 7, wherein capacitance is adjusted outside the stacked body.

12. The device of claim 11, wherein the external electrode extends to at least one of upper and lower portions of the stacked body to partially overlap the internal electrode.

13. The device of claim 7, wherein at least two or more capacitor parts and ESD protection parts are horizontally disposed within the stacked body.

14. The device of claim 13, wherein the internal electrodes are vertically stacked to form one capacitor part and horizontally arranged to form a plurality of capacitor parts.

15. An electronic device comprising a device for preventing an electric shock that is disposed between a metal case and an internal circuit to block an electric shock voltage and bypass an ESD voltage,
wherein the device for preventing the electric shock comprises:
a stacked body in which a plurality of insulation sheets are stacked;
a capacitor part comprising a plurality of internal electrodes disposed in the stacked body;
an ESD protection part comprising at least two or more discharge electrodes disposed on at least a portion of the insulation sheets and at least one ESD protection layer; and
an external electrode disposed on each of at least two side surfaces outside the stacked body and connected top the capacitor part and the ESD protection part, and
the discharge electrode and the internal electrode adjacent to the discharge electrode are connected to the same external electrode.

16. An electronic device comprising a device for preventing an electric shock that is disposed between a metal case and an internal circuit to block an electric shock voltage and bypass an ESD voltage,
wherein the device for preventing the electric shock comprises:
a stacked body in which a plurality of insulation sheets are stacked;
a capacitor part comprising a plurality of internal electrodes disposed in the stacked body;
an ESD protection part comprising at least two or more discharge electrodes disposed on at least a portion of the insulation sheets and at least one ESD protection layer; and
an external electrode disposed on each of at least two side surfaces outside the stacked body and connected top the capacitor part and the ESD protection part, and
the external electrode extends to at least one of upper and lower portions of the stacked body to partially overlap the internal electrode.

17. The electronic device of claim 15 or 16, wherein, when a distance between the discharge electrode and the internal electrode adjacent to the discharge electrode is A, a distance between the discharge electrodes is B, and a distance between the internal electrodes is C, A≤C or A≤B is satisfied.

18. The electronic device of claim 17, wherein, when the uppermost and lowermost insulation sheets have thickness D1 and D2, B≤D1 and B≤D2 are satisfied, and D1 is equal to or different from D2.

19. The electronic device of claim 17, wherein the discharge electrode and the internal electrode have the same thickness.
